# EUROPÄISCHE PATENTSCHRIFT

(11) **EP 3 055 058 B1**
(45) Veröffentlichungstag und Bekanntmachung des Hinweises auf die Patenterteilung: **24.04.2024**
(21) Anmeldenummer: 14781443.8
(22) Anmeldetag: 02.10.2014
(51) Int. Cl.: B01J 19/12

(54) **VERFAHREN ZUR PLASMAKATALYTISCHEN UMSETZUNG VON STOFFEN**
METHOD FOR THE PLASMA-CATALYTIC CONVERSION OF MATERIALS
PROCÉDÉ DE CONVERSION DE SUBSTANCES AVEC CATALYSE ASSISTÉE PAR PLASMA

(30) Priorität: 09.10.2013 DE 102013016660
(43) Veröffentlichungstag der Anmeldung: 17.08.2016
(73) Patentinhaber: Spitzl, Ralf, 53842 Troisdorf (DE)
(72) Erfinder: Spitzl, Ralf, 53842 Troisdorf (DE)
(74) Vertreter: Flaccus, Rolf-Dieter
(86) Internationale Anmeldenummer: PCT/EP2014/002683
(87) Internationale Veröffentlichungsnummer: WO 2015/051893

(56) Entgegenhaltungen:
- WO-A1-2006/123883
- WO-A1-2012/006155
- WO-A2-2004/010454
- DE-A1-102010 020 591
- US-A- 5 015 349
- TAMÁS KOVÁCS ET AL: "Methane reformation using plasma: an initial study", JOURNAL OF PHYSICS D: APPLIED PHYSICS, INSTITUTE OF PHYSICS PUBLISHING LTD, GB, Bd. 39, Nr. 11, 7. Juni 2006 (2006-06-07), Seiten 2391-2400, XP020094506, ISSN: 0022-3727, DOI: 10.1088/0022-3727/39/11/013

## Beschreibung

Die Erfindung betrifft Verfahren zur plasmakatalytischen Umsetzung von Stoffen zwecks Herstellung von chemischen Grundstoffen aus einfachen Ausgangsstoffen.

Die Verwendung von Plasmen für chemische Reaktionen, insbesondere von gasförmigen Reaktanden, ist bekanntlich vorteilhaft, weil unter der Einwirkung eines Plasmas - wegen der dadurch bewirkten Aktivierung der Reaktionskomponenten - eine Beschleunigung der chemischen Reaktionen erreicht werden kann. Deshalb werden solche plasmagestützten Reaktionen oft als "plasmakatalytisch" bezeichnet. Allerdings hat der Einsatz von Plasmen bei chemischen Syntheseverfahren, insbesondere zur Herstellung von chemischen Grundstoffen, bislang kaum Bedeutung erlangt, anders als bei Plasmaverfahren zur Abgasreinigung oder zur Materialbearbeitung.

DE 199 27 540 A1 offenbart ein Abgasreinigungssystem zur Entsorgung von umweltschädlichen oder toxischen Prozessabgasen, wie z. B. von Prozessabgasen aus der Halbleiterfertigung. Derartige Abgase enthalten z. B. SiH₄, PH₃, NF₃, NH₃, HF, B₂H₈, Tetraethoxysilan, C₂F₆, CF₄, CH₃F, Cl₂ oder BCl₃. Das Abgasreinigungssystem weist einen Reaktionsraum mit einer Plasmaquelle auf, sowie einen Eingang für die Einspeisung und einen Auslass für die im Reaktionsraum behandelten Prozessabgase. Der Auslass ist mit einer Flüssigkeitsstrahlpumpe verbunden, welche im Reaktionsraum einen Unterdruck erzeugt, so dass die Abgase zusammen mit der durch die Flüssigkeitsstrahlpumpe geleiteten Flüssigkeit und mit dieser vermischt aus dem Reaktionsraum geleitet werden. Die Flüssigkeitsstrahlpumpe wird mit einem Sorptionsmittel (z. B. Wasser) betrieben, welches feste und lösliche Bestandteile aus dem Abgas entfernt. Um die Effektivität des Auswaschens zu verbessern, können dem Sorptionsmittel bestimmte Stoffe zugesetzt werden. Beispielsweise kann ein basisches Sorptionsmittel zudosiert werden, wenn saure Gase (z. B. HF) ausgewaschen werden sollen. Eine plasmakatalytische Umsetzung von Kohlenwasserstoffen wird in DE 199 27 540 A1 nicht erwähnt.

US 5 277 773 A beschreibt ein Verfahren zur Umsetzung von C₁₊-Kohlenwasserstoffen im Gegenwart von Wasser zu ungesättigten Kohlenwasserstoffen (z. B. Acetylen, Ethylen) und Wasserstoff, unter Einwirkung von Mikrowellenstrahlung.

In WO 2004/010454 A2 wird ein Plasmareaktor zur Durchführung von Gasreaktionen beschrieben, sowie Verfahren zur plasmagestützten Umsetzung von Gasen (z. B. Methan oder Erdgas). Hierbei ist auch der Einsatz von Katalysatoren im Plasmareaktor vorgesehen. Als Syntheseprodukte wird beispielsweise Acetylen oder Benzol erhalten.

US 5 015 349 A beschreibt ein Verfahren, bei welchem ein Kohlenwasserstoff-Material (z. B. Erdgas) in einen Plasmareaktor eingebracht und unter Einwirkung eines Plasmas umgesetzt werden, wobei zusätzlich Katalysatoren zum Einsatz kommen können. Die Reaktionsprodukte (z. B. Ethan, Ethylen, Propan) werden mit einer Kühlfalle abgetrennt.

KOVÀCS T et al. ("Methane reformation using plasma: an initial study"; Journal of Physics D: Applied Physics, Institute of Physics Publishing Ltd., GB, Bd. 39, Nr. 11, 7. Juni 2006, S. 2391-2400) beschreiben Untersuchungen zur plasmakatalytischen Umsetzung von Methan. Hierbei wurde Methan mit Argon als Trägergas durch ein Mikrowellenplasma geleitet und die entstandenen Reaktionsprodukte chemisch analysiert. Als Hauptprodukte wurden Acetylen, Wasserstoff und Ruß gefunden.

WO 2012/006155 A1 beschreibt ein Verfahren zur Herstellung von Synthesegas mittels eines Plasmareaktors, wobei Abgas und Erdgas als Ausgangsstoffe verwendet werden. Das so erzeugte Synthesegas wird in einen Fischer-Tropsch-Reaktor eingespeist, um flüssige Kohlenwasserstoffe zu erzeugen.

WO 2006/123883 A1 beschreibt eine Apparatur und ein Verfahren zur Erzeugung von Wasserstoffgas durch Mikrowellenplasma-Entladung. Hierbei wird z. B. ein gasförmiger Kohlenwasserstoff durch ein dielektrisches Rohr eines Plasmareaktors geleitet und dabei einer Mikrowellenplasma-Entladung ausgesetzt. Die dabei entstehenden Reaktionsprodukte werden durch einen Separator voneinander getrennt. Beispielsweise erhält man bei der Verwendung eines Kohlenwassserstoffs (z. B. Methan) Wasserstoffgas und festen Kohlenstoff als Reaktionsprodukte.

DE 10 2010 020 591 A1 betrifft einen Plasmagenerator, umfassend eine Plasmakammer mit einer Zuführung für ein Plasmagas, eine mit der Plasmakammer verbundene Pumpe, mit der Niederdruck in der Plasmakammer erzeugt werden kann, sowie eine Ionisationseinrichtung zur Erzeugung eines Niederdruckplasmas in der Plasmakammer. Die Pumpe ist als Strahlpumpe ausgebildet, die mit einem Treibmedium betrieben wird und durch die ionisiertes Plasmagas aus der Plasmakammer absaugbar und mit dem Treibmedium vermischbar ist. Der Plasmagenerator ist so ausgebildet, dass der für eine Zündung und Aufrechterhaltung des Niederdruckplasmas erforderliche Niederdruck in der Plasmakammer über die Strahlpumpe eingestellt wird. Der Plasmagenerator kann zur Abscheidung von Beschichtungen eingesetzt werden, wobei als Treibmittel z. B. ein Lack eingesetzt wird. Auch können dem Treibgas und/oder dem Plasmagas gasförmige Prekursoren beigemischt werden, welche durch die Plasmaeinwirkung z. B. durch Polymerisation feste Stoffe erzeugen. Die so erzeugten Plasmapolymere können an einer zu behandelnden Oberfläche als Plasmapolymerbeschichtung abgeschieden werden.

Aufgabe der vorliegenden Erfindung war es deshalb, Verfahren bereitzustellen, welche die Umsetzung von vorzugsweise gasförmigen Ausgangsstoffen ermöglichen, zwecks Herstellung von chemischen Grundstoffen aus preiswerten und leicht verfügbaren Rohstoffen wie z. B. Erdgas, Pyrolysegas oder Biogas.

Überraschenderweise hat sich gezeigt, dass die erfindungsgemäßen plasmakatalytischen Verfahren auf vorteilhafte Weise für eine Vielzahl von chemischen Prozessen genutzt werden können, insbesondere zur Herstellung der verschiedenartigsten chemischen Grundstoffe aus einfachen Rohstoffen (z. B. Erdgas, Biogas, Pyrolysegas). Die erfindungsgemäßen plasmakatalytischen Verfahren zeichnen sich unter anderem durch eine günstige Energiebilanz, erhöhten Durchsatz, hohe Strömungsgeschwindigkeiten, verbesserte Produktausbeuten, sowie durch eine verbesserte Steuerbarkeit und Variabilität der Verfahrensführung aus.

Ferner können einzelne erfindungsgemäße Verfahren als modulare Komponenten miteinander kombiniert werden, beispielsweise um zusätzliche Synthesewege für die plasmakatalytische Herstellung weiterer Verbindungen nutzbar zu machen. Eine Kombination zweier oder mehrere erfindungsgemäßer Verfahren kann insbesondere dadurch verwirklicht werden, dass das in einem ersten Verfahren erzeugte Produkt in mindestens einem weiteren Verfahren als Ausgangsstoff (Edukt) bzw. als Reaktand eingesetzt wird.

Die Erfindung bezieht sich auf Verfahren zur plasmakatalytischen Umsetzung von Stoffen gemäß Hauptanspruch, zwecks Herstellung von chemischen Grundstoffen. Jedoch beschränkt sich die vorliegende Erfindung nicht auf die Herstellung von chemischen Grundstoffen. Unter Grundstoffen oder Grundchemikalien werden allgemein solche Chemikalien verstanden, die in der Regel in großem Maßstab hergestellt werden und als Ausgangsmaterial für verschiedene industrielle Herstellungsverfahren dienen, beispielsweise zur Herstellung von Kunststoffen, Farbstoffen, Düngemitteln, Klebstoffen, Pflanzenschutzmitteln, Arzneimitteln, Tensiden und Detergenzien. Im allgemeinen handelt es sich bei chemischen Grundstoffen um einfach aufgebaute, niedermolekulare Verbindungen.

Die erfindungsgemäßen Verfahren zur plasmagestützten Umsetzung von Stoffen in einem Plasmareaktor zwecks Herstellung von chemischen Grundstoffen zeichnen sich gemäß Hauptanspruch dadurch aus, dass ein kohlenwasserstoffhaltiger Ausgangsstoff, oder ein kohlenwasserstoffhaltiger Ausgangsstoff und mindestens ein aus der CO₂, CO, H₂O, H₂, O₂ und N₂ umfassenden Gruppe ausgewählter Ausgangsstoff, in einem ersten Verfahrensschritt unter Einwirkung eines Plasmas zu einem oder mehreren Zwischenprodukt(en) umgesetzt wird, das/die in mindestens einem nachfolgenden Verfahrensschritt zu einem Reaktionsprodukt umgesetzt wird/werden.

Das im Plasmareaktor befindliche Plasmagas, welches das/die erzeugten Zwischenprodukt(e) enthält, wird
- mittels einer dem Plasmareaktor nachgeschalteten Flüssigkeitsstrahlpumpe gefördert, oder/und
- durch einen Gaswäscher geleitet,
wobei als Treibmittel für die Flüssigkeitsstrahlpumpe oder als Waschflüssigkeit des Gaswäschers eine Flüssigkeit verwendet wird, die einen oder mehrere Katalysatoren oder einen oder mehrere Reaktanden für die weitere Umsetzung des/der genannten Zwischenprodukte(s) enthält.

Der genannte kohlenwasserstoffhaltige Ausgangsstoff ist aus der Gruppe ausgewählt, die aus gesättigten Kohlenwasserstoffen, ungesättigten Kohlenwasserstoffen, unverzweigten Kohlenwasserstoffen, verzweigten Kohlenwasserstoffen, aromatischen Kohlenwasserstoffen, Gemischen solcher Kohlenwasserstoffe und aus Stoffgemischen, welche derartige Kohlenwasserstoffe enthalten, besteht.

Wie oben erwähnt, wird/werden der/die genannte(n) Ausgangsstoff(e) in dem ersten Verfahrensschritt unter Einwirkung eines Plasmas zu einem oder mehreren Zwischenprodukt(en) umgesetzt. Eine genaue Kenntnis der chemischen Zusammensetzung oder der Struktur der plasmakatalytischen Zwischenprodukte ist nicht zwingend erforderlich, kann aber bei Bedarf mittels aus dem Fachwissen bekannter Methoden ermittelt werden. Das/die erhaltene(n) Zwischenprodukt(e) wird/werden in mindestens einem nachfolgenden Verfahrensschritt weiter umgesetzt.

Das/die so hergestellten Reaktionsprodukt(e) können als chemische(r) Grundstoff(e), wie oben erläutert, verwendet werden. Der erwähnte nachfolgende Verfahrensschritt kann unter Zusatz eines oder mehrerer weiterer Reaktanden (Ausgangsstoffe) erfolgen, optional in Gegenwart eines oder mehrerer Katalysatoren, um die Bildung der gewünschten Produkte zu erreichen.

Als kohlenwasserstoffhaltige Ausgangsstoffe kommen vorzugsweise kohlenwasserstoffhaltige Gase, insbesondere Erdgas und Biogas (typische Zusammensetzung: 40-75 Vol.-% Methan, 25-55 Vol.-% CO₂, Rest N₂, H₂S, H₂O und andere Gase), Pyrolysegase (Gase aus Pyrolyseprozessen, z. B. Pyrolyse von Biomasse oder Abfällen), sowie gasförmige Kohlenwasserstoffe, insbesondere Methan, Ethan, Propan, Butan, Isobutan in Betracht, sowie Kombinationen von zwei oder mehreren der vorstehend genannten Stoffe. Allgemein kommen gesättigte und ungesättigte, unverzweigte und verzweigte, sowie aromatische Kohlenwasserstoffe, und Gemische solcher Kohlenwasserstoffe, in Betracht, und Stoffgemische, die derartige Kohlenwasserstoffe enthalten.

Die Erfindung ist aber nicht auf die Verwendung gasförmiger Ausgangsstoffe beschränkt; beispielsweise können auch flüssige Ausgangsstoffe (insbesondere Öle, z. B. Pyrolyse-Öle) oder vergasbare Kohlenwasserstoffe verwendet werden, die unter den im Plasma herrschenden Bedingungen in die Dampf- bzw. Gasphase übergehen, oder feste, vorzugsweise in Partikelform vorliegende Ausgangsstoffe. Feste oder flüssige Ausgangsstoffe werden vorzugweise als Aerosole eingesetzt.

Vorzugsweise werden als kohlenwasserstoffhaltige Ausgangsstoffe ausschließlich gesättigte Kohlenwasserstoffe verwendet, oder der Anteil der gesättigten Kohlenwasserstoffe beträgt jedenfalls mindestens 75 Vol.-%, vorzugsweise mindestens 85 Vol.-%, insbesondere mindestens 95 Vol.-%.

Ein durch die vorliegende Erfindung erzielter Vorteil liegt darin begründet, dass ausgehend von gesättigten Kohlenwasserstoffen eine große Vielfalt von unterschiedlichen Produkten - einschließlich halogenierter Verbindungen, Alkohole, Aldehyde, Ketone, Carbonsäure, CN-Verbindungen - synthetisiert werden kann.

Der kohlenwasserstoffhaltige, vorzugsweise gasförmige Ausgangsstoff kann wahlweise auch in Kombination bzw. als Gemisch mit einem oder mehreren anderen Prozessgasen eingesetzt werden, wie z. B. Stickstoff, Wasser, Kohlenmonoxid, Kohlendioxid. Als Prozessgase können auch inerte Gase verwendet werden, insbesondere Edelgase (z. B. Argon, Helium und/oder Neon). Gemäß einer weiteren Ausführungsform der Erfindung wird Wasserstoff als (zusätzliches) Prozessgas verwendet, weil dadurch - falls erforderlich - eine unerwünschte oder übermäßige Rußbildung verhindert oder reduziert werden kann.

Der erwähnte nachfolgende Verfahrensschritt, oder mindestens einer dieser nachfolgenden Verfahrensschritte, kann unter Einsatz eines oder mehrerer Katalysatoren durchgeführt werden. Die Auswahl des Katalysators richtet sich nach der Art der beabsichtigten Umsetzungsreaktion bzw. der gewünschten Reaktionsprodukte. Die für eine jeweilige Reaktion geeigneten Katalysatoren sind dem Fachmann aus dem allgemeinen Fachwissen bekannt. Beispielsweise können Katalysatoren verwendet werden, die aus der Metalle (z. B. Platin, Eisen, Nickel u. a.), Keramik (z. B. Zeolithe, Aluminium- oder Zirkonoxid), Schwermetallacetylide (insbesondere Kupferacetylid), Metallcarbonyle und Metallcarbonylwasserstoffe umfassenden Gruppe ausgewählt sind.

Auch wenn die Umsetzung der Ausgangsstoffe, wie vorstehend erwähnt, plasmakatalytisch erfolgt, kann es fallweise von Vorteil oder erforderlich sein, dass diese Umsetzung ganz oder teilweise in Gegenwart eines oder mehrerer Katalysatoren erfolgt. Diese Katalysatoren können in den Reaktionsraum (Plasmakammer), in welchem die plasmagestützte Umsetzung stattfindet, eingebracht werden, beispielsweise in Form von (Nano-)Partikeln. Diese Katalysator-Partikel können rezykliert werden, beispielsweise indem sie mittels eines Zyklonabscheiders aus dem gasförmigen Produktstrom abgetrennt und anschließend wieder in den Reaktionsraum des Plasmareaktors zurückgeführt werden. Hinsichtlich der Auswahl geeigneter Katalysatoren gilt das oben Gesagte.

Als Katalysatoren kommen insbesondere Festbettkatalysatoren, Katalysator-Formkörper, in gelöster Form vorliegende Katalysatoren, in suspendierter oder dispergierter Form vorliegende Katalysatoren oder in partikulärer Form (Pulver, Staub) vorliegende Katalysatoren in Betracht, wobei auch zwei oder mehrere unterschiedliche Katalysatortypen miteinander kombiniert werden können.

Das bei der plasmakatalytischen Umsetzung gebildete Zwischenprodukt oder zumindest eines dieser Zwischenprodukte, kann in einen Zwischenspeicher eingebracht werden, bevor es in dem erwähnten nachfolgenden Verfahrensschritt umgesetzt wird. Dies ist insbesondere deshalb vorteilhaft, weil dadurch eine kontinuierliche Durchführung des bzw. eines nachfolgenden Verfahrensschrittes ermöglicht oder erleichtert wird.

Falls die oben beschriebene plasmakatalytische Umsetzung zu einem Gemisch von zwei oder mehreren Zwischenprodukten führt, kann es ebenfalls vorteilhaft sein, dieses Zwischenproduktgemisch (oder den dieses Gemisch enthaltenden Produktstrom) in einem Zwischenspeicher zu speichern, bevor es einer weiteren Behandlung zugeführt wird (z. B. Fraktionieren, Reinigen, Konzentrieren, Extrahieren).

Für die erfindungsgemäße plasmakatalytische Umsetzung werden vorzugsweise nichtthermische Plasmen verwendet, insbesondere durch Mikrowellen angeregte Plasmen (Mikrowellenplasmen). Nichtthermische Plasmen zeichnen sich dadurch aus, dass sich die darin enthaltenen Teilchensorten nicht im thermischen Gleichgewicht befinden, und dass sich derartige Plasmen auch großvolumig (z. B. 1-10 Liter) und auch im Langzeitbetrieb stabil erzeugen lassen und dass sie hohe Stoffdurchsätze und eine optimale Aktivierung der Reaktanden ermöglichen.

Die Verwendung von Mikrowellenplasmen ist unter anderem auch deshalb vorteilhaft, weil sich dadurch hohe Selektivitäten bei der plasmakatalysierten Stoffumsetzung erreichen lassen und eine Bildung von festen Produkten (z. B. Ruß) vermieden oder stark unterdrückt werden kann.

In diesem Zusammenhang wurde überraschenderweise gefunden, dass die Energie-Effizienz und die Selektivität der Plasmaprozesse, insbesondere der erfindungsgemäßen Verfahren, durch die Dimensionierung des dielektrischen Rohres (Rezipienten, insbesondere aus Quarzglas), welches die Wand des Reaktionsraums bildet, erheblich verbessert werden können. Dies ist insbesondere dann der Fall, wenn der freie Durchmesser des rohrförmigen Rezipienten mindestens 4 cm beträgt; dieser Durchmesser kann auch größer sein, insbesondere z. B. 6 bis 20 cm oder größer betragen.

Plasmareaktoren zur Erzeugung von Mikrowellenplasmen sind bereits im Stand der Technik beschrieben worden (z. B. WO 2004/010454 A2; DE 10 2012 007 230 A1; Patentanmeldungen des Anmelders/Erfinders der vorliegenden Anmeldung); derartige Plasmareaktoren sind prinzipiell für die Durchführung der erfindungsgemäßen Verfahren sowie für die erfindungsgemäßen Vorrichtungen geeignet. Allgemein sind solche Mikrowellenplasmaquellen und -reaktoren geeignet und bevorzugt, die in der Lage sind, ein nicht-thermisches, auch im Dauer- oder Langzeitbetrieb stabiles, großvolumiges (z. B. bis 5 1 oder größer) Plasma zu erzeugen und hohe Gasgeschwindigkeiten zu ermöglichen (z. B. 1 m/s bis 500 m/s, oder höher; vorzugsweise 5 bis 200 m/s, besonders bevorzugt 10 bis 150 m/s). Jedoch sind auch Überschallströmungsgeschwindigkeiten möglich.

Vorzugsweise werden die erfindungsgemäßen Verfahren kontinuierlich betrieben, d. h. unter stetiger Zuführung von Ausgangsstoffen (und wahlweise weiteren Prozessgasen) in den Mikrowellenreaktor und unter stetiger Entnahme des die Zwischenprodukte enthaltenden Produktstroms aus dem Reaktor. Nicht umgesetztes Prozessgas oder nicht umgesetzte Ausgangsstoffe können ganz oder teilweise aus dem Produktstrom abgetrennt und wieder in den Reaktor zurückgeführt werden.

Vorzugsweise wird das Mikrowellenplasma bei den erfindungsgemäßen plasmakatalytischen Verfahren im Druckbereich von 10 bis 10.000 hPa, vorzugsweise im Bereich von 20 bis 3.000 hPa, insbesondere im Bereich von 50 bis 1.500 hPa betrieben, insbesondere unter Atmosphärendruckbedingungen (850 bis 1100 hPa, insbesondere 950 bis 1050 hPa; beispielsweise für Acetylensynthese: ca. 200 hPa).

Die erfindungsgemäßen plasmakatalytischen Verfahren werden üblicherweise bei Temperaturen im Bereich von ca. 50 bis 2000 °C, insbesondere 100 bis 1000 °C, durchgeführt. Falls erforderlich, kann die im Reaktionsraum bzw. Plasmareaktor herrschende Temperatur mittels bekannter Heiz- oder Kühlvorrichtungen (z. B. Gaskühlung, Flüssigkeits-Quenchen) in einem bestimmten Bereich eingestellt werden.

Vorzugsweise wird das Verfahren in der Weise durchgeführt, dass in dem Plasmareaktor ein Druckgefälle oder ein Druckgradient, insbesondere ein Unterdruck oder Überdruck relativ zum Umgebungsdruck (Atmosphärendruck), eingestellt wird. Dies kann insbesondere mittels einer oder mehrerer der folgenden Maßnahmen erreicht werden: Steuern oder Regeln des Zustroms der fluiden, insbesondere gasförmigen Ausgangsstoffe in den Reaktor, vorzugsweise mittels einer oder mehrerer Ventile oder/und Pumpen/Kompressoren; Steuern oder Regeln des Ausströmens von Gasen, insbesondere des produkthaltigen Plasmagases, aus dem Plasmareaktor, vorzugsweise mittels einer oder mehrerer Ventile oder/und Pumpen.

Der statische Druck innerhalb der Vorrichtung kann beliebig gewählt bzw. dem jeweiligen Prozess angepasst werden.

Gemäß der Erfindung ist vorgesehen, dass die Umsetzung der Ausgangsstoffe - wie bereits erwähnt - unter Einwirkung eines Plasmas in einem Plasmareaktor erfolgt, und dass das im Plasmareaktor befindliche Plasmagas, welches das/die erzeugten Zwischenprodukt(e) enthält (auch "Produktstrom" genannt), mittels einer dem Plasmareaktor nachgeschalteten Flüssigkeitsstrahlpumpe gefördert werden. Dadurch werden einerseits die Zwischenprodukte kontinuierlich aus dem Reaktionsraum des Reaktors entnommen, andererseits wird durch den von der Flüssigkeitsstrahlpumpe erzeugten Unterdruck eine kontinuierliche Förderung der Ausgangsstoffe (bzw. des die Ausgangsstoffe enthaltenden Plasmagases) in den Reaktor bewirkt. Ferner kann durch Steuerung oder Regelung der Förderleistung der flüssigkeitsstrahlpumpe der gewünschte Prozessdruck im Plasmareaktor eingestellt oder reguliert werden.

Die Verwendung einer Flüssigkeitsstrahlpumpe ist besonders vorteilhaft, weil hier die Möglichkeit besteht, durch die Auswahl des Treibmediums (Treibmittel für die Pumpe) das Verfahren in gewünschter Weise zu beeinflussen. Das in die Flüssigkeitsstrahlpumpe eintretende Treibmedium (Treibmittel), durch welches die Pumpwirkung (Saugwirkung) der Strahlpumpe bewirkt wird, kann sich in der Mischkammer der Strahlpumpe mit dem Saugmedium, d. h. dem Produktstrom, vermischen.

Gemäß einer bevorzugten Ausführungsform wird als Treibmittel ein Lösemittel verwendet, welches in der Weise ausgewählt wird, dass das plasmakatalytisch erzeugte Zwischenprodukt, oder mindestens eines der mittels Plasma erzeugten ZwischenProdukte, in diesem Lösemittel löslich ist. Auf diese Weise kann das betreffende Zwischenprodukt kontinuierlich in dem als Treibmedium dienenden Lösemittel gelöst werden und aus dem Produktstrom abgetrennt werden. Das mit dem/den gelösten Zwischenprodukten angereicherte Treibmedium kann sodann zur weiteren Behandlung an entsprechende Einrichtungen (z. B. Absorptions-/Desorptionswäscher, Fraktionierungskolonnen) weitergeleitet werden. Die gelösten Zwischenprodukte können ggf. auf bekannte Weise aus dem flüssigen Medium ausgetrieben werden (z. B. durch Temperatur- oder Druck-Shift).

Die vorstehend beschriebene Verwendung eines Lösemittels als Treibmittel für die Flüssigkeitsstrahlpumpe ist insbesondere bei der plasmakatalytischen Herstellung von halogenierten Kohlenwasserstoffen von Vorteil. Hierbei wird als Treibmittel ein Lösemittel verwendet, welches in der Weise ausgewählt wird, dass der/die plasmakatalytisch erzeugte(n) Kohlenwasserstoff(e) in dem Treibmittel löslich sind.

Die Verwendung einer Flüssigkeitsstrahlpumpe zum Fördern des Produktstroms bietet ferner die Möglichkeit, den die Zwischenprodukte enthaltenden Produktstrom mit Katalysatoren oder Reaktanden bzw. weiteren Ausgangsstoffen zu vermischen, um die Zwischenprodukte in weiteren Reaktionen umzusetzen, oder um eine vollständigere Umsetzung zu erzielen.

Hierzu wird als Treibmittel für die Flüssigkeitsstrahlpumpe eine Flüssigkeit ausgewählt, die ein oder mehrere Katalysatoren oder ein oder mehrere Reaktanden (oder weitere Ausgangsstoffe, z. B. Kohlenwasserstoffe, Alkoholate oder Ester), vorzugsweise in gelöster oder suspendierter Form, zur weiteren Umsetzung der erhaltenen Zwischenprodukte enthält. Insbesondere kann für die Herstellung halogenierter Kohlenwasserstoffe eine Treibmittelflüssigkeit verwendet werden, die Halogenwasserstoffe zur Halogenierung der plasmakatalytisch erzeugten Zwischenprodukte enthält.

Gemäß Hauptanspruch kann alternativ oder zusätzlich zur vorstehend beschriebenen Methode der Verwendung von Reaktanden enthaltenden Pumpentreibmitteln auch von der Möglichkeit Gebrauch gemacht werden, den Produktstrom mit den darin enthaltenen Zwischenprodukten durch einen Gaswäscher zu leiten, dessen Waschflüssigkeit einen bzw. mehrere entsprechende Reaktanden enthält.

Gemäß einer weiteren bevorzugten Ausführungsform ist vorgesehen, dass der die plasmakatalytisch erzeugten Zwischenprodukt(e) enthaltende Produktstrom durch ein oder mehrere Separationsverfahren getrennt, gereinigt, fraktioniert, destilliert, extrahiert oder angereichert wird. Insbesondere ist vorgesehen, dass das/die plasmakatalytisch erzeugte(n) Zwischenprodukt(e) vor der nachfolgenden chemischen Umsetzung durch ein oder mehrere Separationsverfahren getrennt, gereinigt, fraktioniert, destilliert, extrahiert oder angereichert wird/werden. Hierfür geeignete Einrichtungen und Verfahren, wie Fraktionierungskolonnen, Stripperkolonnen, Membrantrennverfahren etc. sind dem Fachmann bekannt.

Eine oder mehrere der so erhaltenen Fraktionen, oder eines oder mehrere der abgetrennten, gereinigten, extrahierten oder angereicherten Zwischenprodukte, können sodann als Ausgangsstoffe in das plasmakatalytische Verfahren zurückgeführt oder in weiteren, auch unterschiedlichen Reaktionen als Ausgangsstoffe eingesetzt werden, um weitere Produktsorten (insbesondere chemische Grundstoffe) zu erhalten.

Des weiteren ist gemäß einer bevorzugten Ausführungsform vorgesehen, dass der die Zwischenprodukte enthaltende, gasförmige Produktstrom in einem Gaswäscher mit einem Flüssigkeitsstrom in Kontakt gebracht wird, um Bestandteile aus dem Produktstrom (z. B. Produkte, Zwischenprodukte, oder auch Nebenprodukte oder Verunreinigungen) in die Flüssigkeit des Gaswäschers zu überführen und damit aus dem Produktstrom zu entfernen. Als Gaswäscher geeignete Einrichtungen sind dem Fachmann prinzipiell bekannt. Ebenso können beispielsweise Absorber eingesetzt werden.

Vorzugsweise wird als Waschflüssigkeit eine Flüssigkeit ausgewählt, in welcher mindestens eines der Zwischenprodukte löslich ist. Alternativ kann auch eine Flüssigkeit ausgewählt werden, in der mindestens eines der Zwischenprodukte unlöslich ist und ausgefällt wird, oder eine Flüssigkeit, welche eine Umsetzung mindestens eines der Zwischenprodukte zu einem weiteren Produkt bewirkt. Hierzu kann die Waschflüssigkeit beispielsweise Katalysatoren oder Reaktanden (weitere Ausgangsstoffe) enthalten.

Ferner kann es von Vorteil sein, den die Zwischenprodukte enthaltenden Produktstrom vor dem Einbringen in den Gaswäscher bzw. vor einer weiteren Umsetzung einer Fraktionierung oder Aufreinigung zu unterwerfen. Hierfür geeignete Einrichtungen, wie Fraktionierungskolonnen etc. sind dem Fachmann bekannt. Die so erhaltenen Fraktionen oder gereinigten Zwischenprodukte können sodann in einem Gaswäscher bzw. nachfolgenden Prozessapparaturen, wie vorstehend beschrieben, weiter behandelt werden.

Gemäß einer weiteren Ausführungsform ist vorgesehen, dass der unter Einwirkung eines Plasmas erzeugte, gasförmige Produktstrom, der die erwähnten Zwischenprodukte enthält, in zwei oder mehrere Teilströme aufgeteilt wird. Diese Teilströme können sodann in unterschiedlichen Verfahren bzw. mittels unterschiedlicher chemischer Reaktionen weiter behandelt werden, um weitere Produkte zu erhalten, die als chemische Grundstoffe dienen können.

Gemäß einer weiteren, bevorzugten Ausführungsform wird das erfindungsgemäße Verfahren zur plasmakatalytischen Herstellung von ganz oder teilweise halogenierten Kohlenwasserstoffen verwendet. Hierbei werden als Ausgangsstoffe Kohlenwasserstoffe oder kohlenwasserstoffhaltige Gasgemische (insbesondere Methan oder methanhaltige Gasgemische wie z. B. Erdgas, Biogas oder Pyrolysegas), oder eine Kombination von zwei oder mehreren der vorgenannten Stoffe verwendet. Diese Ausgangsstoffe werden - wie oben beschrieben - unter Einwirkung eines Plasmas (d. h. plasmakatalytisch) zu einem oder mehreren Zwischenprodukt(en) umgesetzt, welche(s) sodann durch Reaktion mit mindestens einem Halogen oder mindestens einer halogenhaltigen Verbindung zu ganz oder teilweise halogenierten Kohlenwasserstoffen umgesetzt wird/werden.

Für die oben beschriebene plasmakatalytische Herstellung von halogenierten Kohlenwasserstoffen werden vorzugsweise Halogene aus der Chlor, Brom und Fluor umfassenden Gruppe ausgewählt, oder/und halogenhaltige Verbindungen aus der HCl, HBr und HF umfassenden Gruppe.

Gemäß einer weiteren bevorzugten Ausführungsform wird das erfindungsgemäße plasmakatalytische Verfahren zur Herstellung von Vinylchlorid verwendet. Die als Ausgangsstoffe eingesetzten Kohlenwasserstoffe (insbesondere Methan) werden unter Einwirkung des Plasmas aktiviert und umgesetzt. Als Treibmittel der Flüssigkeitsstrahlpumpe wird eine aus der Salzsäure und Salzsäure-Wasser-Gemisch sowie Mischungen der vorgenannten Flüssigkeiten mit Ethanol umfassenden Gruppe ausgewählte Flüssigkeit verwendet. Wird der Pumpflüssigkeit (Treibmittel) Chlorwasserstoff zugefügt, so werden die unter Einwirkung des Plasmas erhaltenen Zwischenprodukte bei dem nachfolgenden Kontakt mit dem in der Pumpflüssigkeit enthaltenen Chlorwasserstoff zu Vinylchlorid umgesetzt.

Der bei der plasmakatalytischen Umsetzung der kohlenwasserstoffhaltigen Ausgangsstoffe anfallende Wasserstoff kann mittels geeigneter Einrichtungen, beispielsweise durch einen Separator, ganz oder teilweise aus dem Produktstrom abgetrennt werden und anschließend entweder für weitere Syntheseverfahren genutzt oder in den Plasmareaktor zurückgeführt werden (Kreislauf / Recycling). Insbesondere kann der im Plasmaschritt gewonnene (überschüssige) Wasserstoff mit Chlorgas (z.B. aus einer Elektrolyse) zu Salzsäure umgesetzt werden und dann dem plasmakatalytischen Prozess nachfolgenden Waschprozess, der die Salzsäure beispielsweise bei der Umsetzung zu Vinylchlorid verbraucht, zugeführt werden.

Die Abtrennung des Wasserstoffs kann beispielsweise mittels Druckwechseladsorption (Pressure Swing Adsorption, PSA) oder Membranfiltration (z. B. mittels Palladium) erfolgen. Falls erwünscht, kann eine Abtrennung von Methan aus dem Produktstrom mittels kryogener Verfahren oder anderer bekannter Verfahren erfolgen.

Die vorstehend beschriebenen erfindungsgemäßen Verfahren, in den verschiedenen Ausführungsformen, ermöglichen es, ausgehend von einfachen Ausgangsstoffen (wie Kohlenwasserstoffen oder einem Gemisch von zwei oder mehreren Kohlenwasserstoffen, vorzugsweise Methan oder ein methanhaltiges Gasgemisch) mittels plasmakatalytischer Umsetzung und mittels weiterer Umsetzung in dem erwähnten mindestens einen nachfolgenden Verfahrensschritt eine Vielzahl von Produkten oder Zwischenprodukten herzustellen, die als chemische Grundstoffe für weitere Synthesewege dienen können. Hierbei sind insbesondere folgende Beispiele zu nennen:
Vinylester, insbesondere Vinylacetat; Acrylnitril; Ether, insbesondere Dimethylether, Diethylether, Di-n-propylether; Vinylether, insbesondere Methylvinylether, Ethylvinylether, Propylvinylether, Isopropylvinylether; Methanol, Propargylalkohol (2-Propin-1-ol), 2-Butin-1,4-diol, Butandiole, insbesondere Butan-1,4-diol, 2-Methyl-3-butin-2-ol (Methylbutinol), 3-Methyl-3-buten-1-ol (Isoprenol), 3-Methyl-but-1-in-3-ol; ungesättigte Carbonsäuren, insbesondere Acrylsäure (Propensäure) und Methacrylsäure (2-Methylpropensäure); Acrylsäureester, insbesondere Acrylsäuremethylester, Acrylsäureethylester, Acrylsäurebutylester, Acrylsäureisobutylester, Acrylsäure-2-ethylhexylester; Acrylamid (Acrylsäureamid); Carbonsäureamide; Vinylhalogenide, insbesondere Vinylchlorid; Benzol, Styrol, Cyclooctatetraen; Butenin (Vinylacetylen); Chloropren (2-Chlor-1,3-butadien); Acetylen, Ethylen; Blausäure und Nitrile.

Gemäß einer weiteren bevorzugten Ausführungsform wird durch die plasmakatalytische Umsetzung eines kohlenwasserstoffhaltigen Ausgangsstoffes Ethin (Acetylen), Ethen (Ethylen) und/oder Ethan erhalten. Diese Zwischenprodukte können als Ausgangsstoffe in einer Vielzahl von Synthesereaktionen eingesetzt werden; beispielsweise kann Acetylen mittels der bekannten REPPE-Synthesereaktionen umgesetzt werden.

Als Reaktionstypen, welche mittels der erfindungsgemäßen plasmakatalysierten Verfahren durchgeführt werden können, kommen deshalb insbesondere folgende in Betracht: Vinylierung; Ethinylierung; Hydrocarboxylierung; Cyclisierung; Halogenierung.

Ferner können die mit den erfindungsgemäßen Verfahren erhaltenen Produkte oder Zwischenprodukte auf verschiedene Weise weiter umgesetzt, modifiziert oder derivatisiert werden, beispielsweise mittels nachfolgender Pyrolyse oder durch Hydrogenisierungsstufen.

Ferner ist es möglich und vorteilhaft, zwei oder mehrere der erfindungsgemäßen Verfahren parallel oder koordiniert zu betreiben, wobei in den einzelnen Verfahren unterschiedliche Ausgangsstoffe eingesetzt werden können, und/oder unterschiedliche Umsetzungsreaktionen durchgeführt werden können (z. B. durch Zugabe unterschiedlicher Reaktanden oder Katalysatoren), und unterschiedliche Produkte erzeugt werden können.

Dies ermöglicht es, zwei oder mehrere der unterschiedlichen erfindungsgemäßen Verfahren in der Weise parallel oder koordiniert zu betreiben, dass mindestens einer der an einer ersten Umsetzungsreaktion beteiligten Ausgangsstoffe (z. B. CO, Wassergas, H₂, HCN, NH₃) in einem zweiten oder weiteren plasmagestützten Herstellungsverfahren hergestellt wird.

Hierbei ist folgende Ausführungsform besonders bevorzugt: In einem ersten Verfahren wird ein kohlenwasserstoffhaltiger Ausgangsstoff, vorzugsweise Methan oder ein methanhaltiges Gas, unter Einwirkung eines Plasmas (d. h. in einem Plasmareaktor) zu Acetylen umgesetzt (2 CH₄ → C₂H₂ + 3 H₂). Das als Zwischenprodukt gebildete Acetylen wird sodann - wahlweise nach vorheriger Abtrennung von Nebenprodukten oder Verunreinigungen - in mindestens einem darauffolgenden weiteren Verfahren zu verschiedenen Produkten (z. B. chemischen Grundstoffen) umgesetzt. Hierbei kann Acetylen mit mindestens einem weiteren Ausgangsstoff (Reaktand) und/oder in Anwesenheit eines oder mehrerer Katalysatoren umgesetzt werden; als weitere Ausgangsstoffe kommen insbesondere die oben bereits genannten Stoffe in Betracht. Besonders bevorzugt sind hierbei Halogene oder Halogenwasserstoffe, mit denen eine Umsetzung von Acetylen zu den jeweiligen Vinylhalogeniden ermöglicht wird. Die Reaktion von Acetylen mit Chlorwasserstoff zu Vinylchlorid ist hierbei besonders bevorzugt.

Die Umsetzung des Acetylens mit dem/den weiteren Ausgangsstoff(en) kann in der Weise geschehen, dass - wie oben bereits beschrieben - eine Flüssigkeitsstrahlpumpe zum Fördern des acetylenhaltigen Produktgases aus dem Plasmareaktor verwendet wird, und dass bei diesem Vorgang die Beimischung des/der weiteren Ausgangsstoff(e) erfolgt. Dies geschieht in der Weise, dass der/die weiteren Ausgangsstoff(e) (= Reaktanden) dem Treibmittel der Strahlpumpe beigemischt werden. Ebenso können auf diese Weise Katalysatoren beigemischt werden.

Das plasmakatalytisch erzeugte Acetylen kann als Zwischenprodukt für eine Vielzahl von weiteren Reaktionen dienen, welche dem Fachmann aus dem allgemeinen Fachwissen bekannt sind, insbesondere für die REPPE-Synthesen. Letztere umfassen die Vinylierung, Ethinylierung, Hydrocarboxylierung (liefert u. a. Acrylsäure, Acrylester) und Cyclisierung (liefert u. a. Benzol, Cyclooctatetraen, Styrol) von Acetylen. Als Katalysatoren kommen insbesondere Schwermetallacetylide (insbesondere Kupferacetylid), Metallcarbonyle und Metallcarbonylwasserstoffe zum Einsatz.

Als Beispiele für weitere Reaktionen des Acetylens, welche mit den erfindungsgemäßen Verfahren durchgeführt werden können, sind insbesondere folgende zu nennen:
- Addition von Halogenen wie Br oder Cl (liefert u. a. 1,2-Dichlorethen, Tetrachlorethan);
- Hydrierung (zu Ethen/Ethan);
- Umsetzung mit HCl zu Vinylchlorid (katalytische Umsetzung zu Vinylalkohol/Acetaldehyd möglich);
- Carbonylierung (CO/H₂O, Katalysatoren wie z. B. Nickeltetracarbonyl) zu Carbonsäuren (z. B. Propensäure);
- Addition von Alkoholen (ergibt Vinylether);
- Addition von Carbonsäuren (ergibt Vinylester).

Die vorliegende Erfindung umfasst ferner Verfahren zur plasmakatalytischen Herstellung von CN-Verbindungen oder anderen stickstoffhaltigen Verbindungen, wobei ein Methan-StickstoffGemisch unter Einwirkung eines Plasmas, insbesondere eines Mikrowellenplasmas, umgesetzt wird.

Nachfolgend werden beispielhaft einige bevorzugte Anwendungen und Ausführungsformen des erfindungsgemäßen Verfahrens beschrieben, womit verschiedenartige Produkte (oder chemische Grundstoffe), wie nachfolgend beschrieben, erhalten werden können:

### 1) Plasmakatalytisches Verfahren zur Herstellung von Vinylchlorid-Monomer

Hierbei werden Methan und Chlorgas (Cl₂) als gasförmige Ausgangsstoffe (Eduktgase) verwendet; zusätzlich können auch chlorierte Kohlenwasserstoffe, insbesondere 1,2-Dichlorethan, oder Ethylen verwendet werden.

Die Eduktgase werden über eine Zuleitung oder Einlass in einen Plasmareaktor, vorzugsweise einen Mikrowellenplasmareaktor, eingeleitet. Als Plasmareaktor wird vorzugsweise eine Vorrichtung verwendet, wie weiter unter - auch mit Bezugnahme auf die Zeichnungen - genauer beschrieben.

Mittels einer dem Plasmareaktor nachgeschalteten Flüssigkeitsstrahlpumpe (wie bereits weiter oben erwähnt) kann der Druck im Plasmareaktor auf den gewünschten Prozessdruck eingestellt werden. In der Mischkammer der Strahlpumpe kommt es zu einer Vermischung des von der Pumpe geförderten Produktstroms mit dem Treibmittel (Pumpflüssigkeit) der Pumpe.

Als Pumpflüssigkeit (Treibmittel) für die Strahlpumpe kann beispielsweise Salzsäure oder ein Salzsäure-Wasser-Gemisch verwendet werden. Der Zusatz von Chlorwasserstoff in das Treibmittel ist besonders vorteilhaft, weil in diesem Fall auf den Einsatz von Chlorgas (Cl₂) als Eduktgas im Einlass des Plasmareaktors verzichtet werden kann.

Des weiteren ist es bei der plasmakatalytischen Herstellung von Vinylchlorid vorteilhaft, wenn zusätzlich ein Katalysator verwendet wird, beispielsweise HgCl₂/Aktivkohle. Der Katalysator kann mit den Eduktgasen (Ausgangsstoffen) in den Reaktor eingebracht werden oder dem Treibmittel der Strahlpumpe beigemischt werden. Durch Verwendung eines Katalysators lassen sich Ausbeute und Selektivität der Reaktion zusätzlich steigern.

Die Prozesstemperatur liegt vorzugsweise bei ca. 70 °C.

Die Gewinnung des reinen Vinylchlorid-Produkts aus dem Produktstrom kann vorzugsweise mittels Destillation erfolgen, wobei sämtliche unerwünschten Bestandteile abgetrennt werden. Das so erhaltene, hochreine Vinylchlorid kann beispielsweise als Monomer für die Herstellung von PVC eingesetzt werden.

Um die Effizienz des Verfahrens zu steigern, kann das im Produktstrom enthaltene unverbrauchte Prozessgas ganz oder teilweise wieder in den Plasmareaktor zurückgeführt werden. Diese Vorgehensweise ist auf sämtliche hier beschriebenen Verfahren anwendbar.

Ferner ist es vorteilhaft, den im Produktstrom ebenfalls enthaltenen Wasserstoff (der bei der plasmakatalytischen Umsetzung als Nebenprodukt anfällt) mittels eines entsprechenden Separators (z. B. basierend auf Druckwechseladsorption oder Membranfiltration (z. B. mittels Palladium, Hohlfasermembranen etc.)) ganz oder teilweise aus dem Produktstrom abzutrennen und gegebenenfalls für weitere Synthesen zu nutzen. Bei dem beschriebenen Verfahren zur Herstellung von Vinylchlorid fallen pro Mol Vinylchlorid ca. 3 Mol Wasserstoff an, wobei im kontinuierlichen Betrieb 0,5 Mol verbraucht werden (für HCl bzw. für die Vinylchlorid-Synthese). Der überschüssige Wasserstoff (ca. 2,5 Mol pro Mol Vinylchlorid) kann auf die beschriebene Weise abgetrennt werden.

### 2. Plasmakatalytische Umsetzung von Methan zu Vinylacetat

Methan, oder ein methanhaltiges Gas, oder ein anderes kohlenwasserstoffhaltiges Gas/Gasgemisch, wird unter Einwirkung eines Plasmas (vorzugsweise in einem erfindungsgemäßen Mikrowellenreaktor) zu aktivierten Zwischenprodukten umgesetzt.

Wie bei dem weiter oben beschriebenen Verfahren (1) wird auch in diesem Fall eine dem Plasmareaktor nachgeschaltete Flüssigkeitsstrahlpumpe verwendet, um den Produktstrom (mit den erwähnten Zwischenprodukten) zu fördern. Hierbei wird dem Treibmittel (Pumpflüssigkeit) Essigsäure (bis 100%) beigemischt, die als weiterer Reaktand (Ausgangsstoff) dient. Wie weiter oben erwähnt, findet in der Mischkammer der Strahlpumpe eine Vermischung des von der Pumpe geförderten Produktstroms mit dem Treibmittel (Pumpflüssigkeit) - und darin enthaltener Reaktanden (hier: Essigsäure) - der Pumpe statt. Durch die Reaktion der im Produktstrom enthaltenen Zwischenprodukte mit der dem Treibmittel beigemischten Essigsäure kann die Bildung von Vinylacetat erfolgen.

Alternativ können die im Produktstrom enthaltenen Zwischenprodukte auch dadurch mit Essigsäure zur Reaktion gebracht werden, dass der Produktstrom durch einen Gaswäscher geleitet wird, dessen Waschflüssigkeit (Waschmittel) Essigsäure enthält.

Beides kann auch kombiniert werden, um die Ausbeuten zu optimieren.

Zwecks Steigerung von Ausbeute und Selektivität kann auch in diesem Fall ein Katalysator verwendet werden, der beispielsweise dem Treibmittel der Flüssigkeitsstrahlpumpe beigemischt werden kann. Als Katalysatoren kommen für diese Synthesereaktion insbesondere Zinkacetat/Aktivkohle und/oder HgCl₂/Aktivkohle in Betracht.

### 3. Plasmakatalytische Umsetzung von Methan zu Acrylnitril

Methan, oder ein methanhaltiges Gas, oder ein anderes kohlenwasserstoffhaltiges Gas/Gasgemisch, wird - wie oben unter 2. beschrieben - unter Einwirkung eines Plasmas zu aktivierten Zwischenprodukten umgesetzt. Als Treibmittel (Waschmittel) wird Blausäure (HCN) verwendet. Durch Reaktion mit HCN wird Acrylnitril gebildet.

Die in diesem Verfahren eingesetzte Blausäure kann ebenfalls plasmakatalytisch erzeugt werden (siehe unten). Durch Kombination (z. B. parallele, aufeinanderfolgende oder koordinierte Durchführung) der beiden Verfahren kann die in einem ersten Verfahren hergestellte Blausäure als Edukt bzw. Reaktand in dem zweiten Verfahren verwendet werden (Umsetzung zu Methan zu Acrylnitril).

### 4. Plasmakatalytische Umsetzung von Methan zu Vinylether

Analog zu dem unter 2. beschriebenen Verfahren wird Methan, oder ein anderes kohlenwasserstoffhaltiges Gas/Gasgemisch, unter Einwirkung eines Plasmas umgesetzt, wobei als Treibmittel (Waschmittel) der entsprechende Alkohol als weiterer Ausgangsstoff (d. h. als Reaktand) verwendet wird. Beispielsweise führt die Verwendung von Methanol zu Methylvinylether, die Verwendung von Ethanol zu Ethylvinylether, usw..

Als Katalysatoren können z. B. Alkalimetallhydroxide und/oder Alkalimetallalkoxide eingesetzt werden.

### 5. Plasmakatalytische Herstellung von Methanol

Durch plasmakatalytische Umsetzung von CH₄ (oder eines anderen kohlenwasserstoffhaltigen Gases oder Gasgemisches) mit CO₂ und/oder H₂O wird Synthesegas (CO, H₂) erzeugt, aus welchem mittels katalytischer Synthese Methanol erhalten werden kann. Als Katalysatoren können Cu-, Zn- und Cr-haltige Katalysatoren oder ZnO/Cr₂O₃-Katalysatoren verwendet werden. Die Katalysatoren werden, wie erwähnt, dem Treibmittel oder der Waschflüssigkeit beigemischt.

Bezüglich der Selektivität des Verfahrens hat sich die Verwendung eines Plasmareaktors mit einem rohrförmigen Rezipienten mit einem Durchmesser von mindestens 4 cm, vorzugsweise 6 bis 20 cm, oder größer, als besonders günstig herausgestellt.

### 6. Plasmakatalytische Umsetzung von Methan zu Propargylalkohol und But-2-in-1,4-diol (2-Butin-1,4-diol)

Analog zu dem unter 2. beschriebenen Verfahren wird Methan, oder ein anderes kohlenwasserstoffhaltiges Gas oder Gasgemisch, unter Einwirkung eines Plasmas umgesetzt, wobei als Treibmittel (Waschmittel) Formaldehyd als weiterer Ausgangsstoff (d. h. als Reaktand) verwendet wird.

Als Katalysator können z. B. Cu(I)-Salze oder Cu-Acetylid verwendet werden. Das Verfahren wird üblicherweise bei Drücken von 1- bis 20 bar bei einer Temperatur von 90-150 °C durchgeführt.

Der im vorstehend beschriebenen Verfahren anfallende Wasserstoff kann in einem nachfolgenden Schritt zur Hydrierung des But-2-in-1,4-diol verwendet werden, wodurch Butan-1,4-diol erhalten wird.

### 7. Plasmakatalytische Umsetzung von Methan zu Methylbutinol

Analog zu dem unter 2. beschriebenen Verfahren wird Methan, oder ein anderes kohlenwasserstoffhaltiges Gas oder Gasgemisch, unter Einwirkung eines Plasmas umgesetzt, wobei als Treibmittel (Waschmittel) Aceton als weiterer Ausgangsstoff (d. h. als Reaktand) verwendet wird.

### 8. Plasmakatalytische Umsetzung von Methan zu Acrylsäure

Analog zu dem unter 2. beschriebenen Verfahren wird Methan, oder ein anderes kohlenwasserstoffhaltiges Gas oder Gasgemisch, unter Einwirkung eines Plasmas umgesetzt, wobei als Treibmittel (Waschmittel) Wasser verwendet werden kann.

Methan oder ein methanhaltiges Gas wird plasmakatalytisch umgesetzt und das im Produktstrom enthaltene Acetylen wird - ggf. nach Abtrennung mittels Wäscher oder dgl. - mit Wasser und Kohlenmonoxid zur Reaktion gebracht, vorzugsweise durch Verwendung eines Katalysators (z. B. als Festbettkatalysator bzw. Festbettreaktor), wobei Acrylsäure erhalten wird. Als Katalysator kommt z. B. Nickeltetracarbonyl in Betracht.

Das für die Erzeugung von Acrylsäure benötigte Kohlenmonoxid kann in einen zweiten plasmakatalytischen Verfahren erzeugt (Synthesegas-Herstellung; siehe 5.) werden oder wird in einem solchen Verfahren erzeugt.

Durch Kombination (z. B. parallele, aufeinanderfolgende d. h. serielle, bzw. durch koordinierte Durchführung) der beiden Verfahren kann das in einem ersten Verfahren hergestellte CO als Edukt bzw. Reaktand in dem zweiten Verfahren verwendet werden (Umsetzung zu Methan zu Acrylsäure). Dies ermöglicht eine genaue Einstellung der Zusammensetzung des eingesetzten Eduktgases.

Alternativ kann die auf die plasmakatalytische Umsetzung folgende Carbonylierung auch unter Druck und unter Verwendung von carbonylbildenden Metallen (z. B. Fe, Ni, Co) als Katalysator(en) bewirkt werden.

### 9. Plasmakatalytische Umsetzung von Methan zu Acrylsäureestern

Analog zu dem unter 2. beschriebenen Verfahren wird Methan, oder ein anderes kohlenwasserstoffhaltiges Gas oder Gasgemisch, unter Einwirkung eines Plasmas umgesetzt, wobei als Treibmittel (Waschmittel) der entsprechende Alkohol verwendet wird (abhängig von der Art des gewünschten Esters).

Wie unter 8. beschrieben, kann das für die plasmakatalytische Umsetzung von Methan außerdem benötigte Kohlenmonoxid in einem zweiten plasmakatalytischen Verfahren erzeugt werden.

Alternativ kann die auf die plasmakatalytische Umsetzung folgende Carbonylierung auch unter Druck und unter Verwendung von carbonylbildenden Metallen (z. B. Fe, Ni, Co) als Katalysator(en) bewirkt werden.

### 10. Plasmakatalytische Umsetzung von Methan zu Acrylsäureamiden

Analog zu dem unter 2. beschriebenen Verfahren wird Methan, oder ein anderes kohlenwasserstoffhaltiges Gas oder Gasgemisch, unter Einwirkung eines Plasmas umgesetzt, wobei als Treibmittel (Waschmittel) die entsprechenden sekundären Amine verwendet werden (abhängig von der Art des gewünschten Amids) .

Wie unter 8. beschrieben, kann das für die plasmakatalytische Umsetzung von Methan außerdem benötigte Kohlenmonoxid in einem zweiten plasmakatalytischen Verfahren erzeugt werden.

Alternativ kann die auf die plasmakatalytische Umsetzung folgende Carbonylierung auch unter Druck und unter Verwendung von carbonylbildenden Metallen (z. B. Fe, Ni, Co) als Katalysator(en) bewirkt werden.

### 11. Plasmakatalytische Umsetzung von Methan zu Benzol und Styrol

Ein durch plasmakatalytische Umsetzung von Methan (bzw. eines methanhaltigen Gases oder eines anderen kohlenwasserstoffhaltigen Gases/Gasgemisches) erzeugtes Produktgas wird in Gegenwart geeigneter Katalysatoren (z. B. Tricarbonyl-Nickel-Komplexen) zu Benzol und Styrol umgesetzt.

### 12. Plasmakatalytische Umsetzung von Methan zu Cyclooctatetraen

Ein durch plasmakatalytische Umsetzung von Methan (bzw. eines methanhaltigen Gases) erzeugtes Produktgas wird in Gegenwart geeigneter Katalysatoren (z. B. Nickel(II)-cyanid, CaC₂, Tetrahydrofuran) zu Cyclooctatetraen umgesetzt; diese Reaktion erfolgt bei erhöhter Temperatur und erhöhtem Druck (insbesondere bei 60 °C, 15 bar).

### 13. Plasmakatalytische Umsetzung von Methan zu Vinylacetylen

Ein durch plasmakatalytische Umsetzung von Methan (bzw. eines methanhaltigen Gases) oder eines anderen kohlenwasserstoffhaltigen Gases/Gasgemisches erzeugtes Produktgas wird in Gegenwart eines Katalysators (vorzugsweise Kupfer(I)-chlorid) zu Vinylacetylen umgesetzt. Diese katalytische Umsetzung erfolgt vorzugsweise mittels einer Flüssigkeitsstrahlpumpe, wobei der Katalysator dem Treibmittel beigemischt wird, oder mittels eines Gaswäschers, wobei der Katalysator der Waschflüssigkeit beigemischt wird (siehe oben, 2.).

### 14. Plasmakatalytische Umsetzung von Methan zu Chloropren (2-Chlor-1,3-butadien)

Verfahren wie in Nr. 13 beschrieben, jedoch mit einem zusätzlichen Verfahrensschritt, in welchem das erhaltene Vinylacetylen mittels Salzsäure zu Chloropren (2-Chlor-1,3-butadien) umgesetzt wird.

### 15. Abwandlung der Syntheseverfahren Nr. 1 bis 14

Gemäß vorliegender Erfindung sind in den vorgenannten Verfahren beliebige Kohlenwasserstoffe - wie im Hauptanspruch definiert - als Ausgangsmaterial einsetzbar. Hierzu gehören unter anderem methanhaltige Gase (wie Erdgas, Biogas oder Pyrolyse-öle) sowie höhere Kohlenwasserstoffe (> C₂; insbesondere C₂ bis C₁₂), gesättigte und ungesättigte Kohlenwasserstoffe (Alkane, Alkene, Alkine), verzweigtkettige und cyclische Kohlenwasserstoffe.

### 16. Herstellung von CN-Verbindungen

CN-Verbindungen (Nitrile, Cyanverbindungen), insbesondere Blausäure (HCN), lassen sich mit den erfindungsgemäßen plasmakatalytischen Verfahren erhalten, indem Methan (oder ein methanhaltiges Gas, oder andere Kohlenwasserstoffe) zusammen mit Stickstoff unter Einwirkung eines Plasmas, insbesondere eines Mikrowellenplasmas, umgesetzt wird. Vorzugsweise schließt sich daran mindestens ein Verfahren zur Stoffauftrennung an, beispielsweise mittels Gaswäscher, um die einzelnen Produkte zu gewinnen.

Die plasmakatalytisch hergestellte Blausäure kann als Edukt bzw. Reaktand in einem weiteren Syntheseverfahren, welches vorzugsweise ebenfalls ein plasmakatalytisches Verfahren ist, eingesetzt werden, beispielsweise zur Erzeugung von Nitrilen (siehe oben, 3.).

### 17. Herstellung von Ethylen

Zur Herstellung von Ethylen wird Methan oder ein methanhaltiges Gas plasmakatalytisch umgesetzt, wobei Acetylen als Zwischenprodukt gebildet wird. Acetylen wird anschließend durch selektive katalytische Hydrierung in Ethylen überführt (z. B. Platin-, Palladium - oder Nickelkatalysatoren).

Die vorstehend beschriebenen plasmakatalytischen Verfahren (Nr. 1 bis 17) stellen beispielhafte Ausführungsformen dar, die entweder einzeln oder auch in verschiedenartigen Kombinationen jeweils den Gegenstand eines oder mehrerer Patentansprüche bilden können. Des weiteren kann jede dieser Ausführungsformen mit einem oder mehreren Merkmal(en) aus der vorangehenden Beschreibung der Erfindung kombiniert werden.

Nachfolgend wird eine zur Durchführung der im vorangehenden Teil der Beschreibung beschriebenen plasmakatalytischen Verfahren geeignete Vorrichtung mit einem Plasmareaktor beschrieben. Die nachfolgende Beschreibung der Vorrichtung dient lediglich der zusätzlichen Erläuterung der Erfindung; die Vorrichtung selbst ist nicht Gegenstand dieser Erfindung.

Eine solche Vorrichtung weist folgende Merkmale und Bestandteile auf:
a) einen Plasmareaktor mit
   - einer Plasmakammer, in der ein im wesentlichen rohrförmiger Rezipient angeordnet ist, der aus einem mikrowellendurchlässigen, dielektrischen Material besteht, wobei der Innenraum des Rezipienten als Reaktionsraum dient;
   - einer oder mehreren Einlassöffnungen und/oder Zuleitungen zum Einleiten von fluiden Stoffen, insbesondere gasförmigen Ausgangsstoffen und/oder Inertgasen, in den Reaktionsraum;
   - einer oder mehreren Auslassöffnungen und/oder Ableitungen zum Ableiten des das/die Umsetzungsprodukt(e) enthaltenden Produktstroms aus dem Reaktionsraum;
   - eine an der Plasmakammer angeordnete und/oder mit dieser in Verbindung stehende Plasmaquelle, insbesondere eine Mikrowellenplasmaquelle, zur Erzeugung eines Plasmas in der Plasmakammer
b) eine dem Plasmareaktor nachgeschaltete Strahlpumpe, welche über die genannte Ableitung oder über mindestens eine der Ableitungen mit dem Reaktionsraum verbunden ist.

Vorzugsweise ist die Plasmakammer aus Metall hergestellt und zylindrisch (rohrförmig) gestaltet, relativ großvolumig (0,5-10 l, insbesondere 1-5 1), und derart ausgebildet, dass sie von Gasen durchströmt werden kann. Der den Reaktionsraum bildende rohrförmige Rezipient ist aus einem mikrowellendurchlässigen, dielektrischen Material wie z. B. Quarz, Borsilikatglas, Al₂O₃ oder Keramik hergestellt. Die zylindrische Wand des Rezipienten ist im wesentliche parallel zur Wand der Plasmakammer angeordnet.

Es hat sich überraschenderweise gezeigt, dass der Durchmesser des dielektrischen Rohres (d. h. des Rezipienten) einen erheblichen Einfluss auf die Energie-Effizienz und auf die Selektivität der Plasmaprozesse, insbesondere der erfindungsgemäßen Verfahren, hat. Deshalb wird bevorzugt, dass der Durchmesser des rohrförmigen Rezipienten mindestens 4 cm beträgt; dieser Durchmesser kann auch größer sein, insbesondere z. B. 6 bis 20 cm oder größer betragen.

Gemäß einer weiteren Variante umfasst die Vorrichtung einen Plasmareaktor, der
- eine Plasmakammer mit einem darin angeordneten rohrförmigen Rezipienten aus einem mikrowellendurchlässigen, dielektrischen Material, wobei der Innenraum des Rezipienten als Reaktionsraum dient,
- eine oder mehrere Einlassöffnungen und/oder Zuleitungen zum Einleiten von fluiden Stoffen, insbesondere gasförmigen Ausgangsstoffen und/oder Inertgasen, in den Reaktionsraum;
- eine oder mehrere Auslassöffnungen und/oder Ableitungen zum Ableiten des das/die Umsetzungsprodukt(e) enthaltenden Produktstroms aus dem Reaktionsraum und
- eine an der Plasmakammer angeordnete und/oder mit dieser in Verbindung stehende Plasmaquelle, insbesondere eine Mikrowellenplasmaquelle, zur Erzeugung eines Plasmas in der Plasmakammer
aufweist;
wobei der Durchmesser des rohrförmigen Rezipienten mindestens 4 cm, vorzugsweise 6 bis 20 cm oder größer, beträgt.

Bei anderen Anwendungsfällen hingegen kann es vorteilhaft sein, wenn der Durchmesser des Rezipienten kleiner ist als oben angegeben. Beispielsweise kann dies dann der Fall sein, wenn die Wandung des Rezipienten aus einem oder mehreren Katalysatoren besteht oder einen oder mehrere Katalysatoren enthält, so dass die Wand des Rezipienten gleichzeitig als Katalysator für eine im Reaktionsraum ablaufende Reaktion dient, z. B. bei der Verwendung von Al₂O₃ oder eines Al₂O₃-Rohres als Rezipient (Reaktionskammer). Aufgrund des geringeren Durchmessers des Rezipienten wird eine stärkere Plasma-Wandwechselwirkung erhalten, d. h. die Wechselwirkung der im Rezipienten befindlichen Reaktanden mit der katalytisch wirkenden Wand des Rezipienten wird verbessert.

Gemäß einer weiteren Variante umfasst die Vorrichtung einen Plasmareaktor, der
- eine Plasmakammer mit einem darin angeordneten rohrförmigen Rezipienten aus einem mikrowellendurchlässigen, dielektrischen Material, wobei der Innenraum des Rezipienten als Reaktionsraum dient,
- eine oder mehrere Einlassöffnungen und/oder Zuleitungen zum Einleiten von fluiden Stoffen, insbesondere gasförmigen Ausgangsstoffen und/oder Inertgasen, in den Reaktionsraum;
- eine oder mehrere Auslassöffnungen und/oder Ableitungen zum Ableiten des das/die Umsetzungsprodukt(e) enthaltenden Produktstroms aus dem Reaktionsraum und
- eine an der Plasmakammer angeordnete und/oder mit dieser in Verbindung stehende Plasmaquelle, insbesondere eine Mikrowellenplasmaquelle, zur Erzeugung eines Plasmas in der Plasmakammer
aufweist;
wobei die Wand des Rezipienten aus einem Katalysator besteht oder einen Katalysator enthält.

Die Wand des Rezipienten kann aus einem oder mehreren Katalysatoren bestehen oder einen oder mehrere Katalysatoren enthalten (z. B. Al₂O₃), so dass die Wand des Rezipienten gleichzeitig als Katalysator für eine im Reaktionsraum ablaufende Reaktion dient.

Allgemein weist die Plasmakammer ferner Mittel zum Zuführen (d. h. Einkoppeln) einer Mikrowellenstrahlung und zum Erzeugen eines Plasmas in der Plasmakammer auf. Üblicherweise handelt es sich bei diesen Mitteln (oder "Koppelstellen") um Öffnungen, insbesondere Schlitze, die in der Wand der Plasmakammer vorzugsweise regelmäßig angeordnet sind, oder um andere Antennen.

Die Plasmakammer ist üblicherweise als zylindrischer Resonator ausgeführt, der zumindest teilweise von einem vorzugsweise ringförmigen Plasmaresonator (oder Koaxialresonator) umgeben ist, der einen Mikrowellenerzeuger (Mikrowellengenerator) zur Erzeugung eines Plasmas aufweist. Über die erwähnten Koppelstellen kann die Mikrowellenleistung in die Plasmakammer eingekoppelt werden, unter Ausbildung eines Plasmas in der Plasmakammer.

Plasmareaktoren mit den vorstehend beschriebenen Konstruktionsmerkmalen sind dem Fachmann bekannt. Beispielsweise können die in WO 2004/010454 A2 und DE 10 2012 007 230 A1 beschriebenen Plasmareaktoren für die Zwecke der vorliegenden Erfindung genutzt werden.

Eine für die Vorrichtung vorteilhafte Plasmaquelle weist einen Reaktionsraum auf, in dem ein Plasma erzeugt werden kann und zu dem Gase/Stoffe zu- und abgeführt werden können. Vorzugsweise werden die Gase/Stoffe in einem Rohr durch die Plasmaquelle geführt. Weitere Merkmale können zusätzlich vorhanden und vorteilhaft sein, sind aber nicht zwingend erforderlich.

Der Plasmareaktor der oben beschriebenen Vorrichtung weist ferner eine oder mehrere Einlassöffnungen und/oder Zuleitungen zum Einleiten von fluiden Stoffen, insbesondere gasförmigen Ausgangsstoffen und/oder Inertgasen, in den Reaktionsraum auf, sowie eine oder mehrere Auslassöffnungen und/oder Ableitungen zum Ableiten des das/die Umsetzungsprodukt(e) enthaltenden Produktstroms aus dem Reaktionsraum. Die erwähnten Einlassöffnungen, Zuleitungen, Auslassöffnungen oder Ableitungen können mit Mitteln zum Absperren oder Regeln des Durchflusses ausgestattet sein (z. B. Ventile).

Des weiteren kann die Vorrichtung zumindest eine dem Plasmareaktor nachgeschaltete Pumpe, beispielsweise eine Drehschieberpumpe oder Strahlpumpe (insbesondere eine Flüssigkeitsstrahlpumpe) aufweisen, welche über die genannte Ableitung oder über mindestens eine der Ableitungen mit dem Reaktionsraum verbunden ist.

Eine dem Plasmareaktor nachgeschaltete Strahlpumpe ermöglicht es einerseits, den im Plasmareaktor bzw. der Plasmakammer erzeugten Produktstrom (welcher die Umsetzungsprodukte der plasmakatalytischen Reaktion(en) enthält) aus dem Plasmareaktor bzw. der Plasmakammer heraus zu fördern und den gewünschten Prozessdruck einzustellen, und andererseits wird dadurch die Möglichkeit eröffnet, über das verwendete Treibmedium (Pumpflüssigkeit) Reaktanden, Katalysatoren etc. mit dem Produktstrom zu vermischen. Das allgemeine Funktionsprinzip einer solchen Strahlpumpe ist dem Fachmann bekannt.

Auf diese Weise können - wie weiter oben ausgeführt - durch den Zusatz ausgewählter Reaktanden (oder weiterer Ausgangsstoffe), Katalysatoren etc. zu dem Treibmedium, oder durch die Verwendung eines Treibmediums mit ausgewählten Lösungseigenschaften, weitere Umsetzungen oder Modifizierungen der im Produktstrom enthaltenen plasmakatalytischen (Zwischen-)Produkte erreicht werden.

Zu diesem Zweck kann die Strahlpumpe mit einem Vorratsbehälter für die Pumpflüssigkeit (Treibmittel) verbunden sein. Die erwähnten Reaktanden, Katalysatoren, Lösemittel etc. können dem im Vorratsbehälter bevorrateten Treibmittel beigemischt werden.

Des weiteren wird bevorzugt, dass die erwähnte Strahlpumpe(n) einstellbar oder regelbar ist und entsprechende Einrichtungen zum Steuern oder Regeln der Pumpenleistung aufweist. Dadurch kann der im Reaktionsraum herrschende Prozessdruck mittels Regelung oder Steuerung der Pumpenleistung eingestellt oder geregelt werden.

Wie erwähnt, ist die Einstellung eines Druckgefälles oder Druckgradienten im Plasmareaktor (und damit in der Reaktionskammer) von Vorteil. Deshalb ist gemäß einer weiteren Variante vorgesehen, dass die Vorrichtung mit einer oder mehreren Einrichtungen ausgestattet ist, die die Einstellung oder Regelung eines Druckgefälles oder eines Druckgradienten ermöglichen. Diese Einrichtungen sind vorzugsweise aus folgender Gruppe ausgewählt: Ventil(e) an der/den Zufuhrleitung(en) oder Einlassöffnungen des Reaktors; Pumpe(n) oder Kompressor(en) an der/den Zufuhrleitung(en); Ventil(e) an der/den Produktleitung(en) oder Auslassöffnungen des Reaktors; Pumpe(n) an der/den Produktleitung(en) oder Auslassöffnungen des Reaktors. Auch die bereits erwähnten Strahlpumpen (z. B. Flüssigkeitsstrahlpumpen) können zur Einstellung oder Regelung eines Druckgefälles oder eines Druckgradienten verwendet werden.

Die Vorrichtung kann ferner eine oder mehrere Einrichtungen zum Fraktionieren, Konzentrieren und Aufreinigen des Produktstroms aufweisen, vorzugsweise ausgewählt aus der Fraktionierungskolonnen, Rektifikationskolonnen, Destillationskolonnen, Stripperkolonnen, Separatoren, Adsorber, Gaswäscher und Zyklone umfassenden Gruppe.

Der Aufbau und die Funktionsweise derartiger Einrichtungen sind dem Fachmann bekannt.

Die Vorrichtung kann ferner mindestens eine Einrichtung zum Abtrennen einer oder mehrerer Stoffen, insbesondere Umsetzungsprodukte, aus dem Produktstrom aufweisen, vorzugsweise eine Einrichtung zum Abtrennen von Wasserstoff. Der Aufbau und die Funktionsweise derartiger Einrichtungen sind dem Fachmann bekannt. Zum Abtrennen von Wasserstoff kommen insbesondere Einrichtungen zur Durchführung von Druckwechseladsorptions-Verfahren (Pressure Swing Adsorption, PSA) oder (Palladium-)Membranfiltrations-Verfahren in Betracht.

Des weiteren kann die Vorrichtung eine oder mehrere Einrichtungen (z. B. Rohrleitungen, Ventile) aufweisen, welche die Rückführung einer oder mehrerer im Produktstrom enthaltener Produktfraktionen oder Stoffe, insbesondere von Ausgangsstoffen, Prozessgas oder Prozessgasbestandteilen, in den Reaktionsraum ermöglichen.

Vorzugsweise werden diese Rückführungseinrichtungen mit den oben erwähnten Abtrenn-Einrichtungen in der Weise kombiniert, dass einer oder mehrere aus dem Produktstrom abgetrennte Stoffe (z. B. Wasserstoff, Methan) in Reaktionsraum zurückgeführt werden.

Die Vorrichtung kann ferner einen oder mehrere Wärmetauscher aufweisen, welche die Nutzung der anfallenden Prozesswärme ermöglicht/ermöglichen. Der Aufbau und die Funktionsweise solcher Wärmetauscher sind dem Fachmann bekannt.

Gemäß einer weiteren Variante der Vorrichtung ist vorgesehen, dass ein erster Plasmareaktor über mindestens eine Verbindungsleitung mit dem Reaktionsraum eines zweiten oder weiteren Plasmareaktors verbunden ist, welcher vorzugsweise parallel zu oder seriell oder koordiniert mit dem ersten Plasmareaktor betrieben wird. Auf diese Weise ist es möglich, erfindungsgemäße Syntheseverfahren beispielsweise in der Weise durchzuführen, dass ein plasmakatalytisch hergestelltes Produkt (oder Zwischenprodukt) als Ausgangsstoff in einem weiteren plasmakatalytischen Verfahren eingesetzt wird, wie weiter oben beschrieben, oder dass zwei Plasmaverfahren einen dritten Prozess bedienen.

Hierbei kann es vorteilhaft sein, wenn die erwähnte Verbindungsleitung eine oder mehrere dazwischen geschaltete Einrichtungen zum Fördern, Fraktionieren, Konzentrieren und Aufreinigen aufweist, so dass das erwähnte Zwischenprodukt aufgereinigt und/oder konzentriert werden kann, bevor es als Ausgangsstoff in einem weiteren plasmakatalytischen Verfahren eingesetzt wird.

Bei weiteren Varianten der Vorrichtung können einzelne oder mehrere Bestandteile oder Merkmale doppelt oder mehrfach vorhanden sein. Beispielsweise können zwei oder mehrere Plasmareaktoren miteinander kombiniert oder verbunden werden, um eine Produktionsanlage zu erhalten, welche die Durchführung mehrstufiger Synthesewege oder die Herstellung weitere Produkte, z. B. durch Derivatisierung, ermöglicht. Ebenso können beispielsweise auch die erwähnten Einrichtungen zum Fraktionieren, Konzentrieren, Aufreinigen usw., und/oder die erwähnten Rückführungseinrichtungen doppelt oder mehrfach vorhanden sein.

Nachfolgend werden die Vorrichtung und die weiter oben beschriebenen erfindungsgemäßen Verfahren anhand von Zeichnungen näher erläutert. Hierbei handelt es sich um schematische Darstellungen, die lediglich das Funktionsprinzip erläutern sollen, jedoch ohne die Erfindung einzuschränken. Die in den Zeichnungen dargestellten und nachfolgend erläuterten Vorrichtungen sind nicht Gegenstand dieser Erfindung.

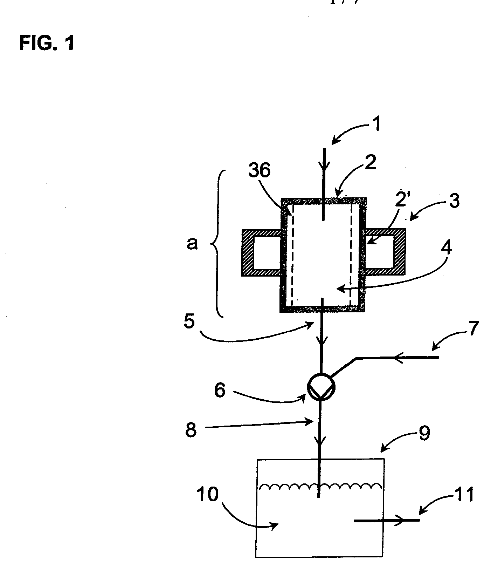

Fig. 1 zeigt eine schematische Schnittdarstellung einer Variante einer zur Durchführung des erfindungsgemäßen Verfahrens geeigneten Vorrichtung, mit einem Plasmareaktor (a), der eine zylindrische Plasmakammer (2) aufweist, die von einem ringförmigen Resonator (3) umgeben ist. In der gemeinsamen Wand (2') von Resonator (3) und Plasmakammer (2) befinden sich Koppelstellen (in Gestalt von regelmäßig angeordneten Schlitzen; nicht dargestellt) zum Einkoppeln der Mikrowellenstrahlung in die Plasmakammer. Der Innenraum der Plasmakammer (2) bildet den Reaktionsraum (4), der durch einen zylindrischer Rezipienten (36) aus einem dieelektrischen Material (z. B. Quarzglas) gebildet wird.

Die Plasmakammer weist eine Zufuhrleitung (1) zum Einleiten von Ausgangsstoffen (Reaktanden) in die Plasmakammer (2) bzw. den Reaktionsraum (4) auf, sowie eine Leitung (5) zum Ableiten des Produktstroms aus dem Reaktionsraum.

Dem Plasmareaktor (a) ist eine Strahlpumpe (6) nachgeschaltet, in der durch eine Treibmedium eine Sog- bzw. Pumpwirkung erzeugt wird, wodurch der Produktstrom durch die Leitung (5) in Pfeilrichtung gefördert wird, und/oder wodurch im Plasmareaktor ein Druckgefälle erzeugt wird. Das Treibmittel wird über die Zufuhrleitung (7) aus einem Vorratsbehälter zugeführt. Das Treibmittel kann, wie weiter oben erläutert, Reaktanden, Katalysatoren, Lösemittel etc. enthalten. Beispielsweise kann das Treibmittel Halogenwasserstoff, z. B. HCl, enthalten, um die entsprechenden halogenierten Produkte zu erzeugen (z. B. Vinylchlorid, wie weiter oben beschrieben).

In der Strahlpumpe (6) kommt es zur Vermischung von Produktstrom und Treibmittel (und ggf. darin enthaltenen Reaktanden etc.) .

Die in Fig. 1 gezeigte Variante der Vorrichtung weist eine Leitung (8) auf, über welche der von der Strahlpumpe (6) geförderte Produktstrom in die Waschflüssigkeit (10) eines Wäschers (9) eingeleitet wird. Die Waschflüssigkeit kann beispielsweise Reaktanden oder/und Katalysatoren zur weiteren Umsetzung der Produkte enthalten, wie weiter oben beschrieben.

Über die Produktleitung (11) kann die produkthaltige Waschflüssigkeit entnommen werden.

Fig. 2 zeigt eine schematische Schnittdarstellung einer weiteren Variante der Vorrichtung, welche eine Abwandlung der in Fig. 1 gezeigten Vorrichtung darstellt.

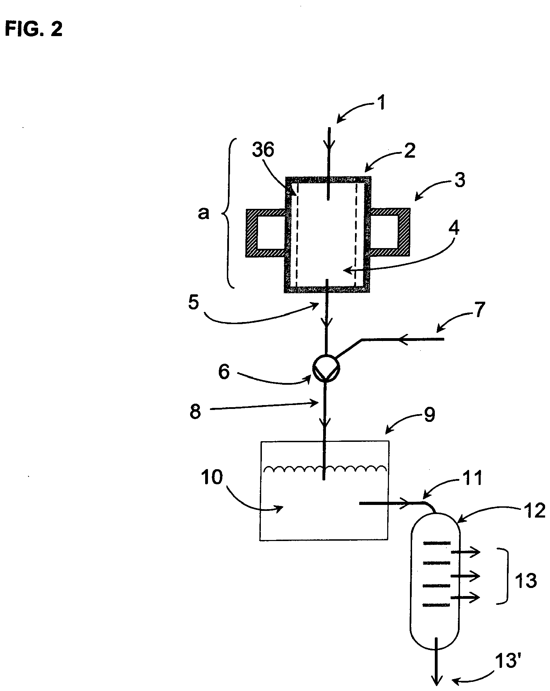

Die Vorrichtung gemäß Fig. 2 weist zusätzlich verfahrenstechnische Einrichtungen auf, mit denen die über die Produktleitung (11) geförderte produkthaltige Waschflüssigkeit fraktioniert und/oder aufgereinigt werden kann. Hierzu werden die in der Waschflüssigkeit enthaltenen Reaktionsprodukte über die Produktleitung (11) durch eine Fraktionierungskolonne (12) geleitet, wobei unterschiedliche Produktfraktionen (13, 13') entnommen werden können.

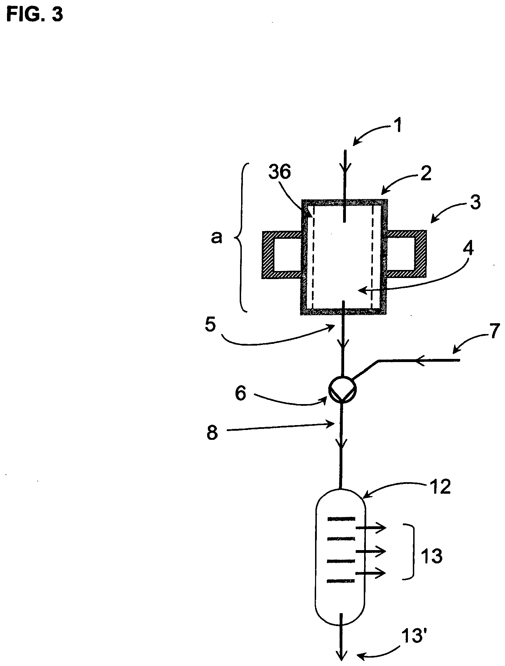

Fig. 3 zeigt eine schematische Schnittdarstellung einer weiteren Variante der Vorrichtung, welche eine Abwandlung der in Fig. 1 u. 2 gezeigten Vorrichtungen darstellt.

Die Vorrichtung gemäß Fig. 3 weist eine Fraktionierungskolonne (12) wie in Fig. 2 auf. Jedoch wird in diesem Fall der von der Strahlpumpe (6) geförderte Produktstrom (vermischt mit dem Treibmedium der Pumpe) direkt über eine Leitung (8) in die Fraktionierungskolonne (12) eingeleitet.

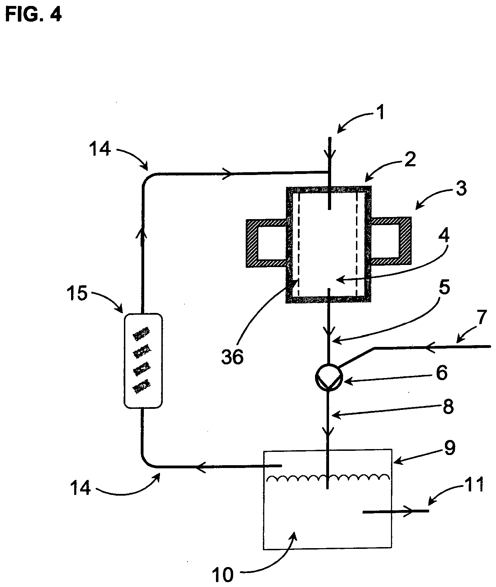

Fig. 4 zeigt eine schematische Schnittdarstellung einer weiteren Variante der Vorrichtung, welche eine Abwandlung der in Fig. 1 gezeigten Vorrichtung darstellt.

Die Vorrichtung gemäß Fig. 4 weist zusätzlich eine Leitung (14) auf, mittels welcher Prozessgase (oder ein Teil der Prozessgase) in einem Kreislauf wieder in den Plasmareaktor zurückgeführt werden können (Gasrückführung (14)). Bei der in Fig. 4 gezeigten Ausführungsform erfolgt die Entnahme der Prozessgase aus dem Gaswäscher (9); sie kann aber auch an einer anderen Stelle erfolgen (z. B. Leitung (8)).

Zusätzlich kann in der Gasrückführung (14) mindestens ein Separator oder Absorber (15) dazwischen geschaltet sein, der es ermöglicht, einzelne Bestandteile (z. B. Wasserstoff) ganz oder teilweise aus dem Prozessgas zu entfernen, bevor dieses in den Plasmareaktor zurückgeführt wird.

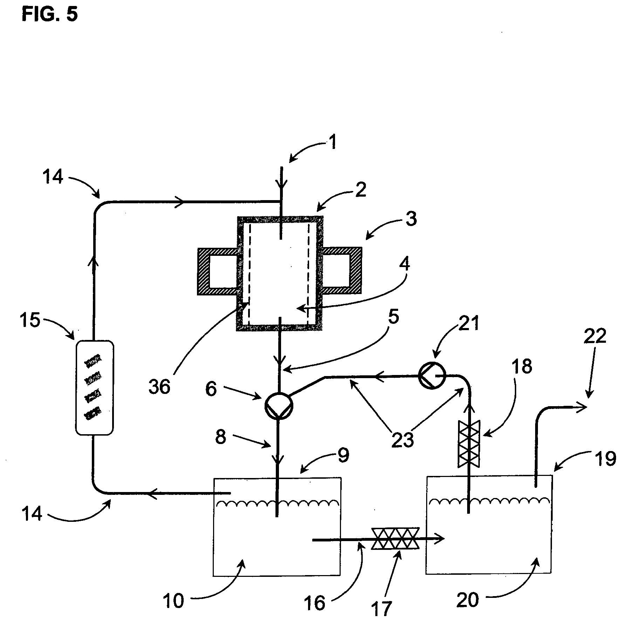

Fig. 5 zeigt eine schematische Schnittdarstellung einer weiteren Variante der Vorrichtung, welche eine Abwandlung der in Fig. 4 gezeigten Vorrichtung darstellt.

Die Vorrichtung gemäß Fig. 5 weist einen zweiten Wäscher oder Waschbehälter (19) mit einer zweiten Waschflüssigkeit (20) auf, die beispielsweise Katalysatoren für eine weitere Umsetzung der über die Leitung (16) eingeleiteten Produkte enthalten kann. Die gewünschten Endprodukte werden über die Produktleitung (22) entnommen. Die Leitung (23) dient der Rückführung von nicht umgesetzten Ausgangsstoffen (bzw. von Zwischenprodukten) in das Treibmittel der Strahlpumpe (6), wobei eine Förderpumpe (21) dazwischen geschaltet sein kann.

Fig. 5 zeigt außerdem Wärmetauscher (17, 18), die zur Abführung der anfallende Prozesswärme dienen, um diese für weitere Prozesse nutzbar zu machen (z. B. zur Erwärmung von Fraktionierungskolonnen).

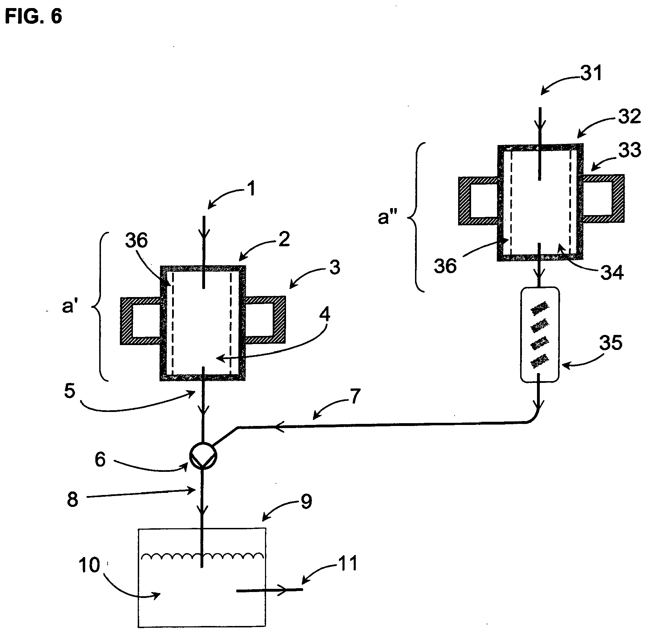

Fig. 6 zeigt eine schematische Schnittdarstellung einer weiteren Variante der Vorrichtung, welche eine Abwandlung der in Fig. 1 gezeigten Vorrichtung darstellt, wobei zwei Plasmareaktoren (a', a") miteinander kombiniert sind.

Das mittels Plasmareaktor (a") durchgeführte plasmakatalytische Verfahren liefert einen Reaktanden bzw. Ausgangsstoff, der über die Leitung (7) der Strahlpumpe (6) zugeführt wird (zusätzlich kann über einen Vorratsbehälter eine Pumpflüssigkeit zugeführt werden, wie in Fig. 1 gezeigt). Der aus dem Plasmareaktor (a") kommende Produktstrom kann einer Fraktionierung mittels Kolonne (35) unterzogen werden.

In der Strahlpumpe (6) kommt es - ähnlich wie bei Fig. 1 beschrieben - zur Vermischung des Produktstroms aus Plasmareaktor (a') und dem Treibmittel, welches den/die mittels Plasmareaktor (a") erzeugten Reaktanden enthält.

Fig. 6 zeigt somit eine Vorrichtung, bei der zwei Plasmareaktoren in einer Vorrichtung in der Weise miteinander kombiniert sind, dass ein in einem ersten plasmakatalytischen Verfahren erzeugtes Produkt als Edukt (Ausgangsstoff) in einem zweiten plasmakatalytischen Verfahren eingesetzt wird, um ein gewünschtes Endprodukt zu erhalten.

### Liste der Bezugszeichen

- a), a'), a"): Plasmareaktor
- 1): Zufuhrleitung (für Edukte)
- 2): Plasmakammer
- 2'): gemeinsame Wand von Plasmakammer u. Plasmaresonator
- 3): Plasmaresonator
- 4): Reaktionsraum (Reaktionskammer)
- 5, 5'): Leitung(en), aus dem Reaktionsraum kommend
- 6, 6'): Strahlpumpe(n) oder Pumpen/Verdichter/Kompressoren
- 7): Zufuhrleitung für Pumpflüssigkeit/Treibmedium (ggf. mit Reaktanden)
- 8): Leitung
- 9): Waschbehälter I
- 10): Waschflüssigkeit I
- 11): Produktleitung
- 12): Kolonne (Rektifikation, Destillation, Fraktionierung, Adsorption etc.)
- 13, 13'): Produktleitungen für Produktfraktionen
- 14): Gasrückführung
- 15): Separator / Adsorber (z. B. für H₂)
- 16): Leitung
- 17): Wärmetauscher
- 18): Wärmetauscher
- 19): Waschbehälter II
- 20): Waschflüssigkeit II
- 21): Pumpe
- 22, 22'): Produktleitung(en)
- 23, 23'): Leitungen
- 31, 31'): Zufuhrleitung(en) II (für Edukte)
- 32): Plasmareaktor II
- 33): Plasmaresonator II
- 34): Reaktionsraum des Plasmareaktors II
- 35): Kolonne (Rektifikation, Destillation, Fraktionierung, Adsorption etc.)
- 36): Rezipient
- 37): Festbettreaktor (katalytisch).

## Patentansprüche

1. Verfahren zur plasmagestützten Umsetzung von Stoffen in einem Plasmareaktor (a, a', a") zwecks Herstellung von chemischen Grundstoffen, wobei
ein kohlenwasserstoffhaltiger Ausgangsstoff, oder ein kohlenwasserstoffhaltiger Ausgangsstoff und mindestens ein aus der CO₂, CO, H₂O, H₂, O₂ und N₂ umfassenden Gruppe ausgewählter Ausgangsstoff, in einem ersten Verfahrensschritt unter Einwirkung eines Plasmas zu einem oder mehreren Zwischenprodukt(en) umgesetzt wird, das/die in mindestens einem nachfolgenden Verfahrensschritt zu einem Reaktionsprodukt umgesetzt wird/werden,
**dadurch gekennzeichnet, dass** das im Plasmareaktor befindliche Plasmagas, welches das/die erzeugten Zwischenprodukt(e) enthält,
- mittels einer dem Plasmareaktor nachgeschalteten Flüssigkeitsstrahlpumpe (6, 6') gefördert wird, oder/und
- durch einen Gaswäscher (9) geleitet wird;
wobei als Treibmittel für die Flüssigkeitsstrahlpumpe oder als Waschflüssigkeit des Gaswäschers eine Flüssigkeit verwendet wird, die einen oder mehrere Katalysatoren oder einen oder mehrere Reaktanden für die weitere Umsetzung des/der genannten Zwischenprodukte(s) enthält;
und wobei der genannte kohlenwasserstoffhaltige Ausgangsstoff aus der Gruppe ausgewählt ist, die aus gesättigten Kohlenwasserstoffen, ungesättigten Kohlenwasserstoffen, unverzweigten Kohlenwasserstoffen, verzweigten Kohlenwasserstoffen, aromatischen Kohlenwasserstoffen, Gemischen solcher Kohlenwasserstoffe und aus Stoffgemischen, welche derartige Kohlenwasserstoffe enthalten, besteht.

2. Verfahren nach Anspruch 1, **dadurch gekennzeichnet, dass** der kohlenwasserstoffhaltige Ausgangsstoff aus der Gruppe ausgewählt ist, die kohlenwasserstoffhaltige Gase, insbesondere Erdgas, Biogas und Pyrolysegas, sowie gasförmige Kohlenwasserstoffe, insbesondere Methan, Ethan, Propan, Butan, Isobutan, flüssige oder vergasbare Kohlenwasserstoffe, sowie Kombinationen der vorstehend genannten Stoffe umfasst.

3. Verfahren nach einem der vorangehenden Ansprüche, **dadurch gekennzeichnet, dass** die vollständige oder teilweise Umsetzung des/der Ausgangsstoffe(s) unter Einsatz eines oder mehrerer Katalysatoren durchgeführt wird.

4. Verfahren nach einem der vorangehenden Ansprüche, **dadurch gekennzeichnet, dass** ein Kohlenwasserstoff, insbesondere Methan, unter Einwirkung eines Plasmas umgesetzt wird und das/die dadurch erzeugte(n) Zwischenprodukt(e) durch Reaktion mit einem Halogen oder einer halogenhaltigen Verbindung zu ganz oder teilweise halogenierten Kohlenwasserstoffen umgesetzt wird/werden.

5. Verfahren nach einem der vorangehenden Ansprüche, **dadurch gekennzeichnet, dass** als kohlenwasserstoffhaltiger Ausgangsstoff Methan oder ein methanhaltiges Gasgemisch verwendet wird, und dieser Ausgangsstoff in einem Plasmareaktor unter Einwirkung eines Plasmas zu einem oder mehreren Zwischenprodukt(en) umgesetzt wird, welche mittels der dem Plasmareaktor nachgeschalteten Flüssigkeitsstrahlpumpe aus dem Reaktor gefördert werden, wobei als Treibmittel der Flüssigkeitsstrahlpumpe eine salzsäurehaltige Flüssigkeit, vorzugsweise Salzsäure oder ein Salzsäure-Wasser-Gemisch, verwendet wird, um den Grundstoff Vinylchlorid als Produkt zu erhalten.

6. Verfahren nach einem der Ansprüche 1 bis 5, **dadurch gekennzeichnet, dass** ein Kohlenwasserstoff oder ein Gemisch von zwei oder mehreren Kohlenwasserstoffen, vorzugsweise Methan oder ein methanhaltiges Gasgemisch, als Ausgangsstoff oder als einer von mehreren Ausgangsstoffen verwendet wird, und dass einer oder mehrere der nachfolgend genannten Stoffe als Produkt(e) oder als Zwischenprodukt(e) erhalten werden: Vinylester, insbesondere Vinylacetat; Acrylnitril; Ether, insbesondere Dimethylether, Diethylether, Di-n-propylether; Vinylether, insbesondere Methylvinylether, Ethylvinylether, Propylvinylether, Isopropylvinylether; Methanol, Propargylalkohol (2-Propin-1-ol), 2-Butin-1,4-diol, Butandiole, insbesondere Butan-1,4-diol, 2-Methyl-3-butin-2-ol (Methylbutinol), 3-Methyl-3-buten-1-ol (Isoprenol), 3-Methyl-but-1-in-3-ol; ungesättigte Carbonsäuren, insbesondere Acrylsäure (Propensäure) und Methacrylsäure (2-Methylpropensäure); Acrylsäureester, insbesondere Acrylsäuremethylester, Acrylsäureethylester, Acrylsäurebutylester, Acrylsäureisobutylester, Acrylsäure-2-ethylhexylester; Acrylamid (Acrylsäureamid); Carbonsäureamide; Vinylhalogenide, insbesondere Vinylchlorid; Benzol, Styrol, Cyclooctatetraen; Butenin (Vinylacetylen); Chloropren (2-Chlor-1,3-butadien); Acetylen, Ethylen; Blausäure und Nitrile.

7. Verfahren nach Anspruch 1, **dadurch gekennzeichnet, dass** eine oder mehrere weitere Reaktionen des im ersten Verfahrensschritt erzeugten Zwischenprodukts Acetylen mit den erfindungsgemäßen Verfahren durchgeführt werden, ausgewählt aus folgender Gruppe von Reaktionen:
- Addition von Halogenen wie Br oder Cl;
- Hydrierung;
- Umsetzung mit Säuren;
- Umsetzung mit HCl zu Vinylchlorid;
- Carbonylierung zu Carbonsäuren;
- Addition von Alkoholen;
- Addition von Carbonsäuren.

8. Verfahren nach Anspruch 1, **dadurch gekennzeichnet, dass** Methan, oder ein methanhaltiges Gas, plasmagestützt umgesetzt wird und die im Produktstrom enthaltenen Reaktionsprodukte durch Verwendung eines Essigsäure enthaltenden Treibmittels oder einer Essigsäure enthaltenden Waschflüssigkeit mit Essigsäure zur Reaktion gebracht werden, wobei Vinylacetat erhalten wird.

9. Verfahren nach Anspruch 1, **dadurch gekennzeichnet, dass** Methan, oder ein methanhaltiges Gas, plasmagestützt umgesetzt wird und die im Produktstrom enthaltenen Reaktionsprodukte durch Verwendung eines HCN enthaltenden Treibmittels oder einer HCN enthaltenden Waschflüssigkeit mit Blausäure (HCN) zur Reaktion gebracht werden, wobei Acrylnitril erhalten wird.

10. Verfahren nach Anspruch 1, **dadurch gekennzeichnet, dass** Methan, oder ein methanhaltiges Gas, plasmagestützt umgesetzt wird und die im Produktstrom enthaltenen Reaktionsprodukte durch Verwendung eines einen Alkohol enthaltenden Treibmittels oder einer einen Alkohol enthaltenden Waschflüssigkeit mit diesem Alkohol zur Reaktion gebracht werden, wobei der entsprechende Vinylether erhalten wird.

11. Verfahren nach Anspruch 1, **dadurch gekennzeichnet, dass** Methan oder ein anderes kohlenwasserstoffhaltiges Gas oder Gasgemisch unter Einwirkung eines Plasmas zu aktivierten Zwischenprodukten umgesetzt wird und der Produktstrom mit den erwähnten Zwischenprodukten mittels der dem Plasmareaktor nachgeschalteten Flüssigkeitsstrahlpumpe aus dem Reaktor gefördert wird, wobei als Treibmittel der Flüssigkeitsstrahlpumpe Formaldehyd verwendet wird, der als weiterer Ausgangsstoff (d. h. als Reaktand) für die Umsetzung der Zwischenprodukte zu Propargylalkohol und But-2-in-1,4-diol dient.

12. Verfahren nach Anspruch 1, **dadurch gekennzeichnet, dass** Methan oder ein anderes kohlenwasserstoffhaltiges Gas oder Gasgemisch unter Einwirkung eines Plasmas zu aktivierten Zwischenprodukten umgesetzt wird und der Produktstrom mit den erwähnten Zwischenprodukten mittels der dem Plasmareaktor nachgeschalteten Flüssigkeitsstrahlpumpe aus dem Reaktor gefördert oder durch den Gaswäscher geleitet wird, wobei als Treibmittel der Flüssigkeitsstrahlpumpe oder als Waschflüssigkeit des Gaswäschers Aceton verwendet wird, das als weiterer Ausgangsstoff (d. h. als Reaktand) für die Umsetzung der Zwischenprodukte zu Methylbutinol dient.

13. Verfahren nach Anspruch 1, **dadurch gekennzeichnet, dass** Methan oder ein anderes kohlenwasserstoffhaltiges Gas oder Gasgemisch unter Einwirkung eines Plasmas zu aktivierten Zwischenprodukten umgesetzt wird und der Produktstrom mit den erwähnten Zwischenprodukten mittels der dem Plasmareaktor nachgeschalteten Flüssigkeitsstrahlpumpe aus dem Reaktor gefördert oder durch den Gaswäscher geleitet wird, wobei als Treibmittel der Flüssigkeitsstrahlpumpe oder als Waschflüssigkeit des Gaswäschers ein Alkohol verwendet wird, der als weiterer Ausgangsstoff (d. h. als Reaktand) für die Umsetzung der Zwischenprodukte dient, und der so gewählt wird, dass als Produkt der entsprechende Acrylsäureester erhalten wird.

## Claims

1. Process for the plasma-assisted conversion of substances in a plasma reactor (a, a', a") for the purpose of producing basic chemicals, wherein
a hydrocarbon-containing starting material, or a hydrocarbon-containing starting material and at least one starting material selected from the group comprising CO₂, CO, H₂O, H₂, O₂ and N₂, is converted in a first process step under the action of a plasma into one or more intermediate product(s), which is/are converted in at least one subsequent process step into a reaction product,
**characterised in that** the plasma gas in the plasma reactor, which plasma gas contains the intermediate product(s) produced,
- is conveyed by means of a liquid jet pump (6, 6') arranged downstream of the plasma reactor, or/and
- is passed through a gas scrubber (9);
wherein a liquid containing one or more catalysts or one or more reactants for the further reaction of said intermediate product(s) is used as the pumping fluid for the liquid jet pump or as the scrubbing liquid of the gas scrubber;
and wherein said hydrocarbon-containing starting material is selected from the group consisting of saturated hydrocarbons, unsaturated hydrocarbons, unbranched hydrocarbons, branched hydrocarbons, aromatic hydrocarbons, mixtures of such hydrocarbons and substance mixtures containing such hydrocarbons.

2. The process according to claim 1, **characterised in that** the hydrocarbon-containing starting material is selected from the group comprising hydrocarbon-containing gases, in particular natural gas, biogas and pyrolysis gas, and gaseous hydrocarbons, in particular methane, ethane, propane, butane, isobutane, liquid or gasifiable hydrocarbons, and combinations of the above-mentioned substances.

3. Process according to any one of the preceding claims, **characterised in that** the complete or partial conversion of the starting material(s) is carried out using one or more catalysts.

4. Process according to any one of the preceding claims, **characterised in that** a hydrocarbon, in particular methane, is reacted under the action of a plasma and the intermediate product(s) produced thereby is/are reacted with a halogen or a halogen-containing compound to form wholly or partially halogenated hydrocarbons.

5. Process according to any one of the preceding claims, **characterised in that** methane or a methane-containing gas mixture is used as the hydrocarbon-containing starting material, and this starting material is converted in a plasma reactor under the action of a plasma into one or more intermediate product(s), which are conveyed out of the reactor by means of the liquid jet pump located downstream of the plasma reactor, a liquid containing hydrochloric acid, preferably hydrochloric acid or a hydrochloric acid/water mixture, being used as the pumping fluid of the liquid jet pump in order to obtain the basic chemical vinyl chloride as the product.

6. Process according to any one of claims 1 to 5, **characterised in that** a hydrocarbon or a mixture of two or more hydrocarbons, preferably methane or a methane-containing gas mixture, is used as starting material or as one of a plurality of starting materials, and **in that** one or more of the following substances are obtained as product(s) or as intermediate product(s):
vinyl ester, in particular vinyl acetate; acrylonitrile; ether, in particular dimethyl ether, diethyl ether, di-n-propyl ether; vinyl ether, in particular methyl vinyl ether, ethyl vinyl ether, propyl vinyl ether, isopropyl vinyl ether; methanol, propargyl alcohol (2-propyn-1-ol), 2-butyne-1,4-diol, butanediols, in particular butane-1,4-diol, 2-methyl-3-butyn-2-ol (methylbutynol), 3-methyl-3-buten-1-ol (isoprenol), 3-methyl-but-1-yn-3-ol; unsaturated carboxylic acids, in particular acrylic acid (propene acid) and methacrylic acid (2-methylpropene acid); acrylic esters, in particular methyl acrylate, ethyl acrylate, butyl acrylate, isobutyl acrylate, acrylic-acid 2-ethylhexyl ester; acrylamide (acrylic-acid amide); carboxylic acid amides; vinyl halides, in particular vinyl chloride; benzene, styrene, cyclooctatetraene; butenyne (vinyl acetylene); chloroprene (2-chloro-1,3-butadiene); acetylene, ethylene; hydrocyanic acid and nitriles.

7. The process according to claim 1, **characterised in that** one or more further reactions of the intermediate product acetylene produced in the first process step is/are carried out using the processes according to the invention, selected from the following group of reactions:
- addition of halogens such as Br or Cl;
- hydrogenation;
- reaction with acids;
- reaction with HCl to vinyl chloride;
- carbonylation to carboxylic acids;
- addition of alcohols;
- addition of carboxylic acids.

8. The process according to claim 1, **characterised in that** methane, or a methane-containing gas, is reacted in a plasma-assisted manner and the reaction products contained in the product stream are reacted with acetic acid by using a pumping fluid containing acetic acid or a scrubbing liquid containing acetic acid, whereby vinyl acetate is obtained.

9. The process according to claim 1, **characterised in that** methane, or a methane-containing gas, is reacted in a plasma-assisted manner and the reaction products contained in the product stream are reacted with hydrocyanic acid (HCN) by using a pumping fluid containing HCN or a scrubbing liquid containing HCN, whereby acrylonitrile is obtained.

10. The process according to claim 1, **characterised in that** methane, or a methane-containing gas, is reacted in a plasma-assisted manner, and by using a pumping fluid containing an alcohol or a scrubbing liquid containing an alcohol the reaction products contained in the product stream are reacted with the said alcohol, whereby the corresponding vinyl ether is obtained.

11. The process according to claim 1, **characterised in that** methane or another hydrocarbon-containing gas or gas mixture is reacted under the action of a plasma to form activated intermediate products and the product stream with the said intermediate products is conveyed out of the reactor by means of the liquid jet pump arranged downstream of the plasma reactor, formaldehyde being used as the pumping fluid of the liquid jet pump, which formaldehyde is used as a further starting material (i.e. as a reactant) for the conversion of the intermediate products to propargyl alcohol and but-2-in-1,4-diol.

12. The process according to claim 1, **characterised in that** methane or another hydrocarbon-containing gas or gas mixture is converted to activated intermediate products under the action of a plasma and the product stream with the said intermediate products is conveyed out of the reactor by means of the liquid jet pump connected downstream of the plasma reactor or is passed through the gas scrubber, acetone being used as the pumping fluid of the liquid jet pump or as the scrubbing liquid of the gas scrubber, which acetone serves as a further starting material (i.e. reactant) for the conversion of the intermediate products to methylbutynol.

13. The process according to claim 1, **characterised in that** methane or another hydrocarbon-containing gas or gas mixture is converted to activated intermediate products under the action of a plasma and the product stream with the said intermediate products is conveyed out of the reactor or passed through the gas scrubber by means of the liquid jet pump located downstream of the plasma reactor, an alcohol being used as the pumping fluid of the liquid jet pump or as the scrubbing liquid of the gas scrubber, which alcohol serves as a further starting material (i.e. as a reactant) for the conversion of the intermediate products and is selected such that the corresponding acrylic ester is obtained as the product.

## Revendications

1. Procédé destiné à la réaction assistée par plasma de matières dans un réacteur à plasma (a, a', a") afin de fabriquer des matières chimiques de base, dans lequel une matière de départ contenant des hydrocarbures, ou bien une matière de départ contenant des hydrocarbures et une matière de départ choisie dans le groupe comprenant CO₂, CO, H₂O, H₂, O₂ et N₂, est fait réagir dans une première étape de procédé sous l'action d'un plasma, pour ainsi obtenir un ou plusieurs produit(s) intermédiaire(s), le(s)quel(s) est/sont amené(s) à réagir, dans une étape de procédé suivante, pour ainsi obtenir un produit de réaction, **caractérisé en ce que** le plasma gazeux qui se trouve dans le réacteur à plasma et contient le(s) produit(s) intermédiaire(s) tel(s) qu'obtenu(s),
- est transporté au moyen d'une pompe à jet de liquide (6, 6') disposée en aval du réacteur à plasma, et/ou
- passé à travers une installation d'épuration de gaz (9) ;
l'agent d'éjection pour ladite pompe à jet de liquide ou le liquide de lavage de ladite installation d'épuration de gaz correspondant à un liquide contant un ou plusieurs catalyseurs ou bien un ou plusieurs réactifs destinés à la réaction ultérieure dudit/desdits produit(s) intermédiaire(s) ;
et ladite matière de départ contenant des hydrocarbures étant choisie dans le groupe constitué par les hydrocarbures saturés, les hydrocarbures insaturés, les hydrocarbures linéaires, les hydrocarbures ramifiés, les hydrocarbures aromatiques, les mélanges de tels hydrocarbures et les mélanges de matières contenant de tels hydrocarbures.

2. Procédé selon la revendication 1, **caractérisé en ce que** la matière de départ contenant des hydrocarbures est choisie dans le groupe comprenant les gaz contenant des hydrocarbures, en particulier le gaz naturel, le biogaz et le gaz de pyrolyse, ainsi que les hydrocarbures gazeux, en particulier le méthane, l'éthane, le propane, le butane, l'isobutane, les hydrocarbures liquides ou gazéifiables ainsi que les combinaisons des matières précitées.

3. Procédé selon l'une des revendications précédentes, **caractérisé en ce que** la réaction totale ou partielle de la / des matière(s) de départ est réalisée en mettant en oeuvre un ou plusieurs catalyseurs.

4. Procédé selon l'une des revendications précédentes, **caractérisé en ce que** l'on fait réagir un hydrocarbure, en particulier le méthane, sous l'action d'un plasma et que l'on transforme le(s) produit(s) intermédiaire(s) obtenu(s) en hydrocarbures totalement ou partiellement halogénés en les soumettant à une réaction avec un halogène ou un composé contenant des halogènes.

5. Procédé selon l'une des revendications précédentes, **caractérisé en ce qu'**en tant que matière de départ, on met en oeuvre du méthane ou un mélange gazeux contenant du méthane, et l'on fait réagir cette matière de départ dans un réacteur à plasma sous l'action d'un plasma, pour ainsi obtenir un ou plusieurs produit(s) intermédiaire(s) le(s)quel(s) sont transportés en dehors du réacteur à plasma au moyen d'une pompe à jet de liquide disposée en aval, l'agent d'éjection de la pompe à jet de liquide étant un liquide contenant de l'acide hydrochlorique, de préférence l'acide chlorhydrique ou un mélange acide hydrochlorique / eau, pour ainsi obtenir la matière de base chlorure de vinyle comme produit.

6. Procédé selon l'une des revendications 1 à 5, **caractérisé en ce que** l'on met en oeuvre, en tant que matière de départ ou en tant qu'une parmi plusieurs matières de départ, un hydrocarbure ou un mélange de deux ou plusieurs hydrocarbures, de préférence le méthane ou un mélange gazeux contenant du méthane, et que l'on obtient en tant que produit(s) ou en tant que produit(s) intermédiaire(s) un ou plusieurs des produits cités ci-après : des esters vinyliques, en particulier l'acétate de vinyle ; l'acrylonitrile ; des éthers, en particulier le diméthyléther, le diéthyléther, le di-n-propyléther ; des éthers vinyliques, en particulier le méthylvinyléther, l'éthylvinyléther, le propylvinyléther, l'isopropylvinyléther; le méthanol, l'alcool propargylique (prop-2-yn-1-ol), le but-2-yn-1,4-diol, les butandiols, en particulier le butan-1,4-diol, le 2-méthylbut-3-yn-2-ol (méthylbutynol), le 3-méthylbut-3-en-1-ol (isoprénol), le 3-méthylbut-1-yn-3-ol; des acides carboxyliques insaturés, en particulier l'acide acrylique (acide propénoïque) et l'acide méthacrylique (acide 2-méthylpropénoïque) ; les esters d'acide acrylique, en particulier l'acrylate de méthyle, l'acrylate d'éthyle, l'acrylate de butyle, l'acrylate d'isobutyle, l'acrylate de 2-éthylhexyle ; l'acrylamide (amide d'acide acrylique) ; des amides d'acides carboxyliques ; des halogénures de vinyle, en particulier le chlorure de vinyle ; le benzène, le styrène, le cyclooctatétraène ; le butényne (vinylacétylène) ; le chloroprène (2-chlorobuta-1,3-diène) ; l'acétylène, l'éthylène ; l'acide cyanhydrique et les nitriles.

7. Procédé selon la revendication 1, **caractérisé en ce que** l'on soumet de l'acétylène, en tant que produit intermédiaire obtenu à la première étape de procédé, à une ou plusieurs autres réactions en mettant en oeuvre le procédé selon l'invention, choisies dans le groupe suivant de réactions :
- addition d'halogènes tels que Br ou Cl ;
- hydrogénation ;
- réaction avec des acides ;
- réaction avec du HCl pour obtenir du chlorure de vinyle ;
- carbonylation pour obtenir des acides carboxyliques ;
- addition d'alcools ;
- addition d'acides carboxyliques.

8. Procédé selon la revendication 1, **caractérisé en ce que** l'on fait réagir du méthane, ou un gaz contenant du méthane, de manière assistée par plasma et que l'on fait réagir les produits de réaction, contenus dans le flux de produits, avec de l'acide acétique en mettant en oeuvre un agent d'éjection contenant de l'acide acétique ou un liquide de lavage contenant de l'acide acétique, pour ainsi obtenir de l'acétate de vinyle.

9. Procédé selon la revendication 1, **caractérisé en ce que** l'on fait réagir du méthane, ou un gaz contenant du méthane, de manière assistée par plasma et que l'on fait réagir les produits de réaction, contenus dans le flux de produits, avec de l'acide cyanhydrique (HCN) en mettant en oeuvre un agent d'éjection contenant du HCN ou un liquide de lavage contenant du HCN, pour ainsi obtenir de l'acrylonitrile.

10. Procédé selon la revendication 1, **caractérisé en ce que** l'on fait réagir du méthane, ou un gaz contenant du méthane, de manière assistée par plasma et que l'on fait réagir les produits de réaction contenus dans le flux de produits avec un alcool en mettant en oeuvre un agent d'éjection contenant cet alcool ou un liquide de lavage contenant cet alcool, pour ainsi obtenir le l'éther vinylique correspondant.

11. Procédé selon la revendication 1, **caractérisé en ce que** l'on fait réagir du méthane ou bien un autre gaz ou mélange gazeux contenant des hydrocarbures, sous l'action d'un plasma pour ainsi obtenir des produits intermédiaires activés et l'on transporte le flux de produits comportant lesdits produits intermédiaires en dehors du réacteur à plasma au moyen d'une pompe à jet de liquide disposée en aval dudit réacteur, en mettant en oeuvre du formaldéhyde comme agent d'éjection de ladite pompe à jet de liquide, le formaldéhyde servant alors de matière de départ supplémentaire (c'est-à-dire de réactif) entrant dans la réaction des produits intermédiaires en alcool propargylique et en but-2-yn-1,4-diol.

12. Procédé selon la revendication 1, **caractérisé en ce que** l'on fait réagir du méthane ou bien un autre gaz ou mélange gazeux contenant des hydrocarbures, sous l'action d'un plasma pour ainsi obtenir des produits intermédiaires activés et ensuite transporter le flux de produits comportant lesdits produits intermédiaires en dehors du réacteur à plasma au moyen de la pompe à jet de liquide disposée en aval dudit réacteur ou bien le faire passer à travers une installation d'épuration de gaz, en mettant en oeuvre de l'acétone comme agent d'éjection de ladite pompe à jet de liquide ou comme liquide de lavage de ladite installation d'épuration de gaz, l'acétone servant alors de matière de départ supplémentaire (c'est-à-dire de réactif) entrant dans la réaction des produits intermédiaires en méthylbutynol.

13. Procédé selon la revendication 1, **caractérisé en ce que** l'on fait réagir du méthane ou bien un autre gaz ou mélange gazeux contenant des hydrocarbures, sous l'action d'un plasma pour ainsi obtenir des produits intermédiaires activés et ensuite transporter le flux de produits comportant lesdits produits intermédiaires en dehors du réacteur à plasma au moyen de la pompe à jet de liquide disposée en aval dudit réacteur ou bien le faire passer à travers une installation d'épuration de gaz, en mettant en oeuvre un alcool comme agent d'éjection de ladite pompe à jet de liquide ou comme liquide de lavage de ladite installation d'épuration de gaz, l'alcool servant alors de matière de départ supplémentaire (c'est-à-dire de réactif) entrant dans la réaction des produits intermédiaires et étant choisi de manière à obtenir comme produit l'ester d'acide acrylique correspondant.
